Europäisches Patentamt

European Patent Office

Office européen des brevets

(19)

(11) Numéro de publication : **0 667 680 A1**

# (12) DEMANDE DE BREVET EUROPEEN

(21) Numéro de dépôt : 95400259.8

(22) Date de dépôt : 08.02.95

(51) Int. Cl.⁶ : **H03M 7/30, H04N 7/28**

(30) Priorité : **11.02.94 FR 9401578**

(43) Date de publication de la demande :
**16.08.95 Bulletin 95/33**

(84) Etats contractants désignés :
**DE GB NL**

(71) Demandeur : **TELEDIFFUSION DE FRANCE**
**10, rue d'Oradour sur Glane**
**F-75015 Paris (FR)**

(72) Inventeur : **Laprevote, Arnaud**
**1 rue de Tortue**
**F-57050 Metz (FR)**
Inventeur : **Barnaba,Jean-Marie**
**13 rue de l'Abbé Grégoire**
**F-57250 Moyeuvre-Grande (FR)**

(74) Mandataire : **Rodhain, Claude et al**
**Cabinet Claude Rodhain S.A.**
**3, rue Moncey**
**F-75009 Paris (FR)**

(54) **Procédé et dispositif de quantification vectorielle d'un signal numérique, notamment appliqué à la compression d'images numériques.**

(57) L'invention concerne un procédé de quantification vectorielle et un dispositif pour la mise en oeuvre de ce procédé.

Selon l'invention, on compare un vecteur d'entrée ($X_i$), présenté sous un format série, signé, le bit de plus faible poids en premier, au quantificateur et on le compare à des vecteurs ($W_j$) de même dimension, stockés dans un dictionnaire, en une ou plusieurs vagues successives. Le quantificateur vectoriel comprend autant de modules élémentaires ($QV_n$) que de vecteurs à comparer. Chaque module élève un drapeau, le dernier drapeau levé désigne le module ayant vu la distance minimale entre le vecteur d'entrée et le vecteur ($W_j$) du dictionnaire qui lui est attribué. Les autres modules sont éliminés. Un calculateur d'adresse (CA) détermine l'adresse ($AD_{Wj}$) de ce vecteur. Si plusieurs vagues sont traitées, la distance minimale trouvée dans les vagues précédentes est mémorisée ($M_D$).

Application notamment à la compression d'images numériques en temps réel

FIG_6

La présente invention concerne un procédé de quantification vectorielle d'un signal numérique, notamment pour une application dans le domaine de la compression des images numériques.

De façon encore plus précise, la présente invention trouve une application avantageuse dans le domaine de la compression, en temps réel, d'images numériques mobiles.

L'invention concerne également un dispositif pour la mise en oeuvre d'un tel procédé.

La compression d'images est devenue un élément clé pour la transmission de signaux numériques. On connaît deux types principaux de techniques de compression d'images, techniques qui peuvent éventuellement s'associer :

- les premières techniques utilisent la corrélation spatiale (quantification scalaire, quantification vectorielle, transformées diverses telles que : Transformée Cosinus Discrète ou T.C.D., Ondelettes, etc..); et
- les techniques d'estimation et/ou de compensations qui utilisent les redondances temporelles.

Ces techniques offrent des taux de compression différents. Leur utilisation est déterminée par diverses considérations techniques et financières : taux de compression à atteindre, complexité de mise en oeuvre, coût, etc..

La présente invention s'intéresse plus particulièrement aux techniques de compression d'images numériques mettant en oeuvre la quantification vectorielle. Il a été démontré, en effet, que la quantification vectorielle était plus performante que la quantification scalaire.

La technique de Quantification Vectorielle repose sur la théorie de l'information de SHANNON concernant le débit et la distorsion. D'après cette théorie fondamentale, la compression est plus élevée en travaillant sur des vecteurs que sur des scalaires, et son efficacité est proportionnelle à la dimension de ces vecteurs.

De plus, il apparaît que l'encodage de source est optimisé lorsqu'on travaille sur des blocs de taille déterminée x×y.

La Quantification Vectorielle est un procédé de codage. De façon succincte, il consiste à décrire un signal à coder en un nombre déterminé de vecteurs. De façon remarquable, certaines formes de vecteurs apparaissent très souvent, d'autres formes sont plus rares, voire inexistantes.

A partir de cette constatation, on constitue un dictionnaire contenant les vecteurs les plus fréquents et on y recherche le vecteur le plus proche du vecteur à coder. Ce dictionnaire étant commun à un organe émetteur et à un organe récepteur, il suffit alors de transmettre l'indice ou adresse du vecteur du dictionnaire.

Les performances de ce procédé de codage dépendent de la formation des vecteurs, de la pertinence du dictionnaire choisi (longueur et méthode de génération) et de la mesure choisie pour comparer deux vecteurs.

De façon avantageuse, dans le cadre de l'invention, on utilisera préférentiellement des vecteurs de 2 à 16 octets signés, issus de la transformation en Cosinus Discret T.C.D. de blocs d'images de 8×8 bits.

On compare ensuite chaque vecteur à ceux d'un dictionnaire comprenant 16, 64 ou 256 vecteurs (ou plus). La génération du dictionnaire proprement dite est basée sur des propriétés statistiques de l'image. Diverses méthodes sont connues. On peut, par exemple utiliser l'algorithme dit "LBG" (Linde-Buzo-Gray).

Pour comparer les vecteurs à coder et les vecteurs du dictionnaire, on utilise la notion de distance. Pour ce faire, différents algorithmes sont connus et sont rappelés ci-après. On peut calculer, notamment :

- la Distance Euclidienne, soit

$$\sum_{i=0}^{k-1} (X_i - W_i)^2$$

avec $X$ = vecteur d'entrée ,
$W$ = vecteur du dictionnaire (indépendant du type de distance choisie) et $k$ dimension commune aux vecteurs;

- la Distance Absolue, soit

$$\sum_{i=0}^{k-1} |X_i - W_i| \; ;$$

- la Distance Pondérée, soit

$$\sum_{i=0}^{k-1} \frac{|X_i - W_i|}{2^i} \; ;$$

ou
- la Distance Supérieure, soit

$$\max_{i=0,k-1} \left( |X_i - W_i| \right),$$

ou Distance de Minkowski.

L'expérience montre que le type de distance choisi influe peu sur le résultat, aussi dans le cadre de l'invention on utilisera de façon préférentielle, pour des raisons de simplicité, la distance absolue.

Dans ce qui suit, pour fixer les idées, on admettra , sans que cela soit limitatif en quoi que ce soit de la portée de l'invention, que la chaîne complète de compression d'une image numérique comprend les trois phases suivantes :

- $Ph_1$ : découpage d'une image en noir et blanc de 256×256×8 bits en blocs carrés de 8×8 bits et transformation en Transformée Cosinus Discrète T.C.D. de ces blocs;
- $Ph_2$ : quantification vectorielle en vecteurs de dimensions 3 ou 5, codés à l'aide d'un dictionnaire DICO de 16, 64 ou 256 vecteurs; et
- $Ph_3$ : encodage de HUFFMANN des informations binaires ainsi obtenues.

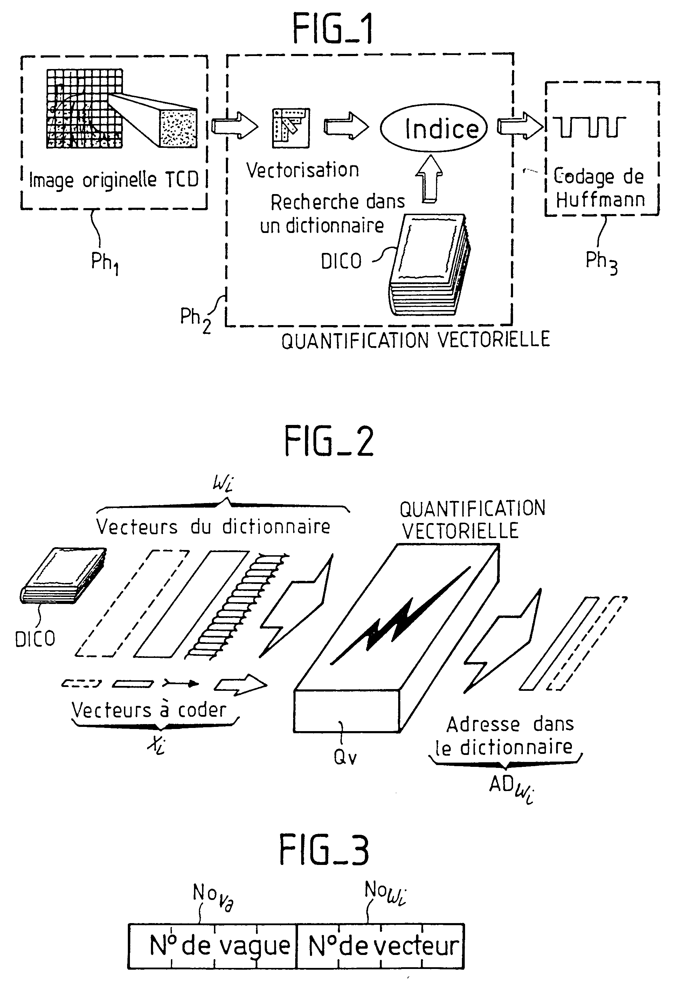

La figure 1 annexée à la présente description illustre de façon schématique la chaîne complète de compression et les différentes étapes du procédé qui vient d'être rappelé.

La longueur des vecteurs, le choix et la taille du dictionnaire déterminent le taux final de compression de l'image et par là même les dégradations apportées à celle-ci.

A la décompression, les opérations inverses sont effectuées. La décompression est une opération plus aisée à réaliser et autorise un algorithme simplifié rapide.

Le procédé de codage rappelé a été divulgué, par exemple, dans la Thèse de l'Université de Metz de Jamal BAINA intitulée "Codage Hybride Adaptatif d'Images en Vue de la Transmission Bas Débit : logiciel et matériel", janvier 92.

En ce qui concerne plus particulièrement la quantification vectorielle proprement dite, divers procédés et quantificateurs mettant en oeuvre ces procédés sont connus. Quelques types de quantificateurs vectoriels vont être brièvement évoqués ci-après.

Un premier type de quantificateur selon l'art connu a été développé par la "Brigham Young University" et fabriqué par la société DARPA MOSIS sous la forme d'un circuit intégré à grande échelle ("VLSI"). L'algorithme utilisé est du type "MRRVQ" ("Mean Residual Reflected Vector Quantizer", c'est-à-dire basé sur la différence des moindres carrés d'un vecteur réfléchi). Cette réalisation est décrite dans l'article de Brent E. NELSON et Christopher J. READ : " A Bit Serial VLSI Vector Quantizer", paru dans IEEE d'avril 1986.

Bien qu'intéressant pour certaines applications, ce type de structure est beaucoup trop lent lorsqu'il s'agit d'effectuer un traitement en temps réel, tel que la compression d'images numériques. En outre, dans ce cas, les dimensions de la surface de silicium nécessaire sont aussi beaucoup trop importantes.

Un deuxième type de quantificateur vectoriel fait appel à une architecture dite "systolique", c'est-à-dire constituée de macro-éléments répétés un nombre déterminé de fois et qui sont reliés les uns aux autres.

Un exemple de ce type d'architecture est décrit dans l'article de P. A. RAMAMOORTHY et al : "Bit-Serial VLSI Implementation of Vector Quantizer for Real-Time Image Coding", paru dans IEEE d'octobre 1989.

L'algorithme utilisé dans le dispositif décrit fait appel au calcul de la Distance Euclidienne.

Cette architecture présente plusieurs avantages : configuration et cellules répétitives, quantification en continue et logique de commande simple.

Cependant, comme précédemment, elle est gourmande en surface de silicium et nécessite un grand nombre d'entrées/sorties.

En outre, elle est difficilement exploitable dans l'état actuel de la technique, en raison de l'important niveau d'intégration et du nombre de connexions externes qui lui sont nécessaires. Enfin l'inconvénient majeur provient de l'interconnexion des macro cellules qui fait croître le nombre de coup d'horloge proportionnellement aux nombre de vecteurs traités.

Un troisième type de quantificateur vectoriel a été développé pour des applications de la logique floue. Des quantificateurs vectoriels de ce type sont réalisés sous forme de composants (circuits intégrés) en technologie CMOS et sont disponibles dans le commerce sous la marque MICRO DEVICES. De façon plus précise, il existe deux configurations, diffusées sous les références MD 12210 Fuzzy Set Comparator et MD 1212 Fuzzy Data Correlator.

Le premier composant met notamment en oeuvre un réseau neuronal et calcule la distance de HAMMING entre deux vecteurs, en mode bit à bit, ou calcule la distance absolue, dès que les composantes des vecteurs ont une taille supérieure à un bit.

De nouveau, ce composant n'est pas destiné à l'application compression d'image en temps réel. Même s'il était possible d'augmenter significativement sa fréquence de fonctionnement, le temps de traitement étant directement proportionnel au nombre et à la dimension des vecteurs, on atteindrait rapidement le maximum de ses possibilités. L'architecture de ce composant n'est donc pas adaptée aux types d'applications préférentielles visées par l'invention.

Le second composant est un corrélateur qui calcule la distance de HAMMING entre un vecteur de longueur maximale de 128 bits et une trame de même profondeur mémorisée dans le composant au départ de chaque corrélation.

Ce composant est destiné à la comparaison de divers type de signaux numériques : domaines du Radar et du Sonar, de la synchronisation, reconnaissance et comparaison d'images.

Cependant son utilisation pour le codage d'image n'est pas possible car la distance de HAMMING n'est pas adaptée pour la compression d'images numériques.

L'invention se propose de pallier les inconvénients des dispositifs de l'art connu, dont certains viennent d'être rappelés. Elle se fixe pour but principal un procédé autorisant la compression en temps réel d'images numériques, ainsi qu'un dispositif quantificateur vectoriel mettant en oeuvre le procédé.

Pour ce faire, l'invention propose une architecture bit série. Celle-ci est composée d'un ensemble de macro éléments, qui associés les uns aux autres, permettent de calculer la différence entre deux vecteurs. Le premier vecteur est dit vecteur d'entrée et le second est contenu dans un dictionnaire. De façon préférentielle, l'algorithme utilisé fait appel au calcul de la distance absolue $\Sigma |X_k - W_k|$ pour $k = 1$ à $k_{max}$ avec k dimension du vecteur.

L'invention a donc pour objet un procédé de quantification vectorielle d'un signal numérique comprenant les étapes de conversion de ce signal en un vecteur à quantifier, au format série signé, de comparaison de ce vecteur à quantifier avec des vecteurs d'un dictionnaire de même dimension que le vecteur à quantifier, de détermination des distances binaires entre le vecteur à quantifier et les vecteurs du dictionnaire, de sélection de la distance minimale et de calcul de l'adresse du vecteur du dictionnaire correspondant à ce vecteur, caractérisé en ce que,

- l'étape de comparaison consiste à comparer, bits à bits, le vecteur à quantifier simultanément avec un nombre déterminé de vecteurs du dictionnaire;
- l'étape de détermination des distances consiste à générer simultanément des mots binaires représentant les distances entre le vecteur à quantifier et les vecteurs du dictionnaire; et
- l'étape de sélection de la distance minimale consiste à générer un signal de drapeau associé à chaque mot binaire et positionné à un premier état logique, à effectuer une séquence de comparaisons simultanées des bits desdits mots, en commençant par les bits de plus fort poids, à émettre pour chaque bit nul de chaque mot binaire un signal détectant cet état, à émettre un signal supplémentaire représentant le "OU" logique de tous ces signaux, à un premier état logique lorsqu'au moins un des bits des mots binaires est nul, à comparer les bits de chaque mot binaire à ce signal supplémentaire, à commuter lesdits signaux de drapeau des mots binaires, du premier état logique à l'état logique complémentaire, si le bit en cours de comparaison a la valeur "un" et si le signal supplémentaire est au premier état logique, et à éliminer les mots binaires associés à ces signaux de drapeau des comparaisons subséquentes, et à déterminer à partir des signaux de drapeau restés audit premier état l'adresse du vecteur du dictionnaire le plus proche du vecteur à quantifier.

L'invention a encore pour objet un dispositif quantificateur vectoriel pour la mise en oeuvre de ce procédé.

La structure du dispositif offre de nombreux avantages et parmi ceux-ci les avantages suivants :
- Le nombre de pads d'entrées/sorties est limité à une taille minimale;
- Les cellules sont toutes identiques et donc facilement reproductibles;
- Le résultat de la comparaison donne directement la distance minimale;
- Son architecture permet d'associer plusieurs quantificateurs vectoriels sans pour autant augmenter le temps de traitement;
- La taille du dictionnaire peut être variable avec le même quantificateur vectoriel. Il suffit d'effectuer une lecture par vague des vecteurs à quantifier. La contrepartie est que le temps de traitement est multiplié par le nombre de vagues.
- La logique de commande et de gestion nécessaire est très simple; et
- La dimension des vecteurs est aisément adaptable aux besoins.

L'invention sera mieux comprise et d'autres caractéristiques et avantages apparaîtront à la lecture de la description qui suit en référence aux figures annexées, et parmi lesquelles :
- La figure 1 illustre schématiquement une chaîne complète de compression d'images numériques intégrant une étape de quantification vectorielle;

- La figure 2 illustre schématiquement les étapes de la quantification vectorielle;
- La figure 3 illustre le codage de l'adresse d'un vecteur, selon un mode de réalisation préférée de l'invention;
- La figure 4 illustre schématiquement le format des vecteurs d'entrée à coder et des vecteurs du dictionnaire;
- La figure 5 illustre le déroulement des étapes de la recherche du vecteur du dictionnaire le plus proche du vecteur à coder;
- La figure 6 illustre schématiquement un exemple de quantificateur vectoriel selon un mode de réalisation préféré de l'invention;
- La figure 7 est un chronogramme explicitant le processus de recherche de distance minimale;
- La figure 8 représente de façon schématique un exemple de réalisation d'un module quantificateur élémentaire;
- la figure 9 illustre un exemple de soustracteur utilisé dans le module quantificateur élémentaire de la figure 8;
- La figure 10 est un chronogramme illustrant le fonctionnement de ce soustracteur;
- La figure 11 illustre un exemple de registre à décalage utilisé dans le module quantificateur élémentaire de la figure 8;
- La figure 12 est un chronogramme illustrant le fonctionnement de ce registre;
- La figure 13 illustre un exemple de circuit 3 calculateur de valeur absolue utilisé dans le module quantificateur élémentaire de la figure 8;
- Le chronogramme de la figure 14 illustre trois exemples de calcul de valeur absolue effectués par le calculateur de la figure 13;
- La figure 15 illustre un exemple d'additionneur utilisé dans le module quantificateur élémentaire de la figure 8;
- Le chronogramme de la figure 16 illustre cinq additions effectuées par l'additionneur de la figure 14;
- La figure 17 illustre un registre à décalage bidirectionnel utilisé dans le module quantificateur élémentaire de la figure 8;
- La figure 18 est un chronogramme illustrant la marche des signaux dans le registre à décalage bidirectionnel de la figure 17;
- La figure 19 illustre un exemple de comparateur élémentaire utilisé dans le module quantificateur élémentaire de la figure 8;
- La figure 20 représente schématiquement l'ensemble des comparateurs du quantificateur vectoriel de la figure 6;
- Les figures 21 et 22 illustrent deux exemples de comparaisons de distances effectuées par les comparateurs de la figure 20;
- La figure 23 illustre un exemple de mémoire utilisée pour le stockage de la plus courte distance trouvée dans les vagues précédentes;
- Les figures 24 et 25 sont deux chronogrammes explicitant la mémorisation et la sortie de ces distances dans et hors de la mémoire de la figure 23;
- La figure 26 illustre les circuits complets de comparaison d'un quantificateur vectoriel, incluant le circuit de comparaison des circuits de mémoire de la plus courte distance trouvée pendant les vagues précédentes;
- La figure 27 illustre un exemple de réalisation du calculateur d'adresse de la figure 6;
- La figure 28 et 29 sont deux chronogrammes illustrant l'encodage d'adresse lors d'une première et d'une seconde vague de vecteurs, à l'aide du calculateur d'adresse de la figure 27;
- Les figures 30 à 32 illustrent la mise en parallèle de plusieurs quantificateurs selon trois modes de réalisation;
- La figure 33 illustre schématiquement un exemple d'une architecture d'un système de compression d'image incluant un quantificateur vectoriel selon l'invention.

Pour fixer les idées, sans que cela soit limitatif de la portée de l'invention, on se placera dans le cadre défini ci-après. La quantification vectorielle sera mise en oeuvre pour un procédé de compression d'images numériques comprenant les phases $Ph_1$ à $Ph_3$ précédemment décrites et illustrées par la figure 1 : découpage d'une image en noir et blanc de $256 \times 256 \times 8$ bits en blocs carrés de $8 \times 8 \times 8$ bits (ou $8 \times 8$ pixels) et transformation en Transformée Cosinus Discrète T.C.D. de ces blocs, quantification vectorielle en vecteurs de dimensions 3 ou 5, codés à l'aide d'un dictionnaire DICO de 16, 64 ou 256 vecteurs, et encodage de HUFFMANN des informations binaires ainsi obtenues.

Le principe de la compression vectorielle, commun à l'art connu, est illustré plus particulièrement par la figure 2. Les vecteurs à coder $X_i$, ou vecteurs d'entrée, sont présentés au quantificateur vectoriel QV qui les compare à une suite de vecteurs $W_i$ contenus dans un dictionnaire DICO. L'élaboration de ce dictionnaire DICO s'effectue selon des méthodes également communes à l'art connu, par exemple en mettant en oeuvre l'algorithme de Linde-Buzo-Gray déjà évoqué. Le nombre de ces vecteurs $W_i$ est naturellement moins important que le nombre possible de vecteur $X_i$ pour qu'il puisse y avoir compression. La dimension k des vecteurs $W_i$ est la même que celle des vecteurs $X_i$. Typiquement le dictionnaire DICO comprend 16, 64 ou 256 vecteurs.

Dans le cadre du procédé de l'invention, pour comparer les vecteurs, on utilisera de façon préférentielle la distance absolue : $d_M = \Sigma \left| X_k - W_k \right|$ pour $k = 1$ à $k_{max}$. De façon plus précise, selon un mode de réalisation préférée de l'invention, le quantificateur QV réalise la fonction suivante : comparaison d'un vecteur $X_i$ de 3 ou 5 octets signés, à une ou plusieurs vagues de 16 vecteurs $W_i$ simultanés. Sur sa sortie, le quantificateur QV génère un indice ou adresse $AD_{Wi}$ du vecteur $W_i$ du dictionnaire le plus proche, au sens de la distance $d_M$, du vecteur d'entrée $X_i$ à quantifier.

Dans un exemple particulier, illustré par la figure 3, cette adresse $AD_{Wi}$ est codée sur 8 bits, les quatre bits de poids les plus forts représentant le numéro de vague $No_{Va}$ et les quatre bits de poids les plus faibles le numéro de vecteur $No_{Wi}$ du dictionnaire DICO. Lorsqu'il y a égalité entre les distances du vecteur d'entrée $X_i$ aux vecteurs $W_i$ du dictionnaire DICO, il n'y a pas de moyen a priori pour décider qu'un de ces vecteurs est le plus pertinent. En sortie du quantificateur QV, un seul des vecteurs $W_i$ est désigné. Un moyen simple est d'accorder la priorité au premier vecteur dans une vague et à la première vague dans le dictionnaire DICO, s'il y a plusieurs vagues. En outre, il est possible d'ordonner le dictionnaire DICO pour favoriser des vecteurs particuliers.

Selon une des caractéristiques importantes de l'invention, les vecteurs à quantifier, c'est-à-dire à coder, $X_i$ sont présentés en entrée du quantificateur QV sous forme série, coordonnée par coordonnée, en partant du bit de poids le plus faible ou "LSB" selon la terminologie anglo-saxonne ( de "Low Significant Bit"), en passant par le bit de poids le plus élevé ou "MSB" (de "Most Significant Bit") et en finissant par le bit de signe. Cette disposition permet le calcul direct de distance, comme il le sera explicité ultérieurement. Ce vecteur à coder $X_i$ est présenté au quantificateur vectoriel en simultanéité avec une vague d'un nombre déterminé de vecteurs $W_i$ du dictionnaire DICO, par exemple quatre vecteurs selon un exemple de réalisation qui sera détaillé ci-après.

Selon un mode préféré de réalisation de l'invention, plusieurs vagues successives de vecteurs $W_i$ sont présentées au quantificateur QV. Dans ce cas, pour les vagues suivantes, il faut répéter le même vecteur d'entré pour le comparer aux vecteurs $W_i$ des vagues successives. Après épuisement de tous les vecteurs $W_i$ du dictionnaire DICO, le quantificateur QV génère sur sa sortie un mot binaire $AD_{Wi}$ représentant l'adresse du vecteur le plus proche du vecteur à coder $X_i$.

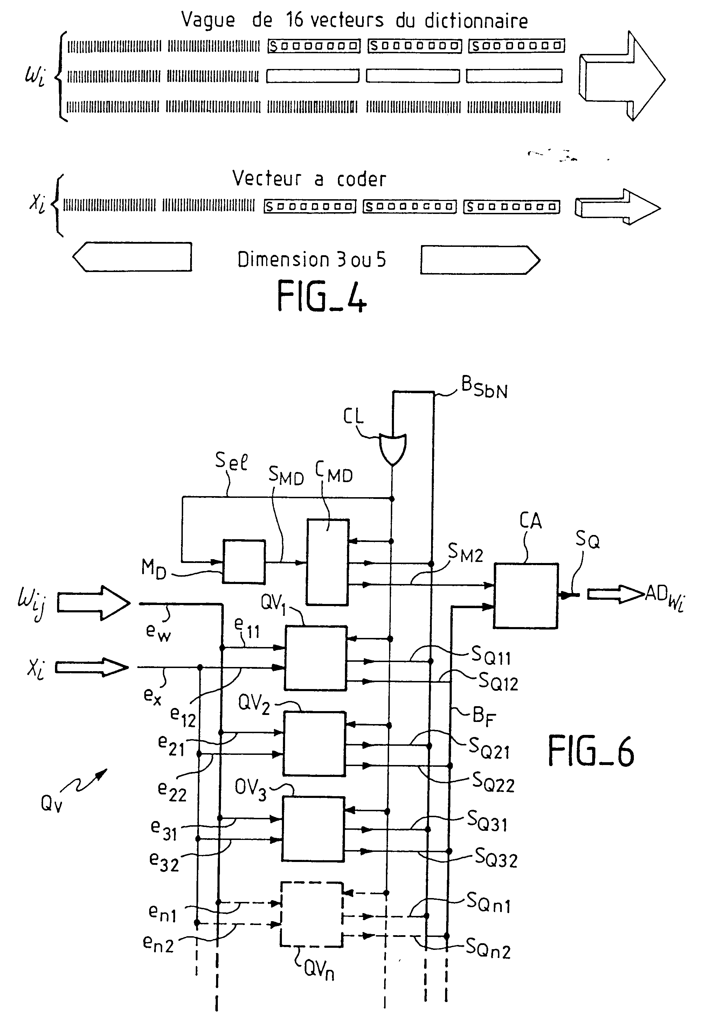

La figure 4 illustre schématiquement le format des vecteurs $X_i$ et $W_i$. Les vecteurs, dans l'exemple particulier illustré par la figure 4, peuvent avoir les dimensions 3 (traits pleins sur la figure) ou 5 (traits pleins et hachurés). Le sigle S sur la figure identifie le bit de signe.

Les données d'entrée du quantificateur QV sont les vecteurs $X_i$, les données de sortie sont les adresses $AD_{Wi}$. Pendant le processus de quantification d'une série de vecteurs $X_i$, par exemple ceux représentant une image source, le dictionnaire DICO reste le même. Physiquement, de façon habituelle, les vecteurs $W_i$ du dictionnaire DICO sont enregistrés dans une mémoire externe.

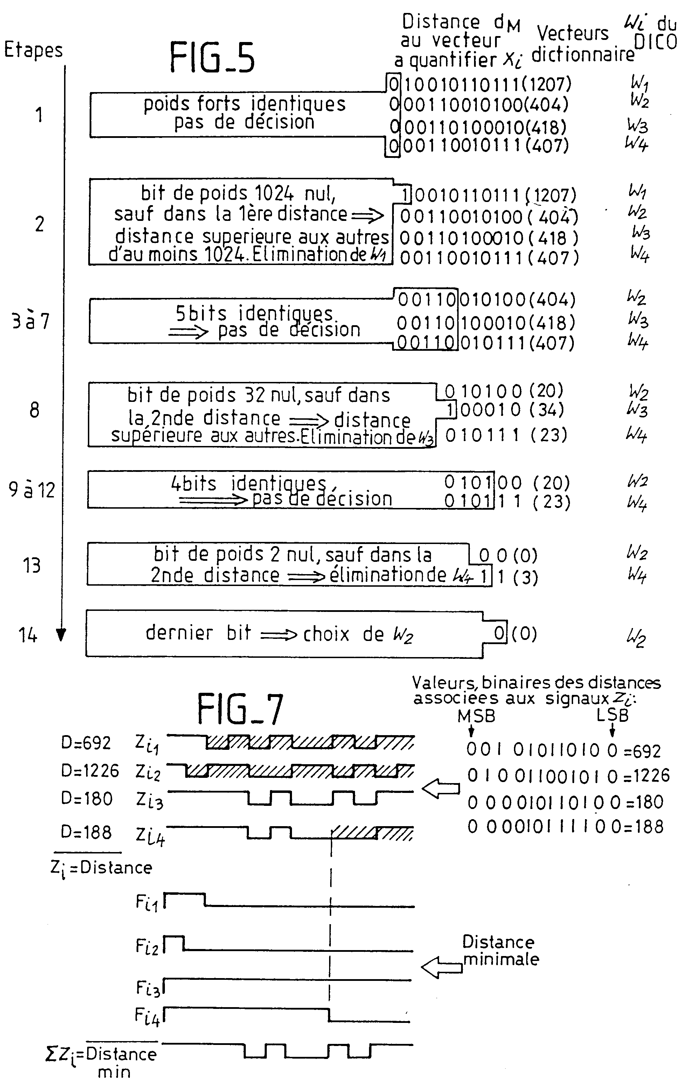

La figure 5 illustre, sur un cas particulier, le déroulement des étapes de la recherche du vecteur $W_i$ du dictionnaire DICO le plus proche du vecteur à coder $X_i$, selon le procédé selon l'invention.

La figure 6, pour sa part, illustre schématiquement un exemple d'architecture de dispositif quantificateur vectoriel selon un mode de réalisation préféré de l'invention. Selon une caractéristique importante, le quantificateur vectoriel QV est du type modulaire, chaque module élémentaire de quantification $QV_1$ à $QV_n$ calcule, notamment, la distance absolue entre le vecteur d'entrée $X_i$ et le vecteur du dictionnaire $W_i$ dont il a la charge.

Dans l'exemple précis illustré, sur la figure 6, on a considéré qu'il n'y a qu'une seule vague de quatre vecteurs $W_1$, $W_2$, $W_3$ et $W_4$, et que les distances binaires sont calculées sur 12 bits. Il y aura donc quatre modules $QV_1$ à $QV_4$.

Si l'on se reporte de nouveau à la figure 5, à l'étape 1, on constate que le bit de poids le plus fort des quatre distances associées aux vecteurs $W_1$, $W_2$, $W_3$ et $W_4$ sont identiques. Le quantificateur vectoriel QV ne peut donc prendre de décision.

A l'étape 2, on constate que le bit de poids 1024 est nul sauf pour la première distance. Le quantificateur vectoriel QV élimine le vecteur $W_1$.

Aux étapes 3 à 7, les 5 bits suivants sont tous identiques. Le quantificateur vectoriel QV ne peut pas prendre de décision.

A l'étape 8, le bit de poids 32 est nul, sauf dans la deuxième distance. Le quantificateur vectoriel QV élimine le vecteur $W_3$.

Aux étapes 9 à 12, les 4 bits suivants sont tous identiques. Le quantificateur vectoriel QV ne peut prendre

6

de décision.

A l'étape 13, le bit de poids 2 est nul sauf dans la seconde distance. Le quantificateur vectoriel QV élimine le vecteur $W_1$.

A l'étape 14, on arrive au dernier bit, ce qui entraîne le choix du vecteur W2, c'est ce vecteur du dictionnaire DICO qui présente la plus petite distance binaire avec le vecteur d'entrée $X_i$.

Après cette étape de choix, l'adresse $AD_{Wi}$ de ce vecteur $W_i$ est calculée par un module de calcul d'adresse CA. C'est cette adresse $AD_{Wi}$ qui est transmise, sous la forme d'un mot binaire, sur la sortie $S_Q$ du quantificateur vectoriel QV.

Dans le cas général, et de façon préférentielle, on procède par vagues successives de vecteurs $W_i$, typiquement des vagues de 16 vecteurs. On compare les distances absolues obtenues par chaque module $QV_1$ à $QV_n$, sur $x$ bits, $x$ étant égal à 12 dans l'exemple illustré. On suppose, pour fixer les idées, que le dictionnaire DICO (figures 1 et 2) comporte 64 vecteurs $W_i$. Il y aura donc quatre vagues successives de vecteurs $W_i$.

Si on se reporte maintenant à la figure 6, chacun des vecteurs $Wiy$ de chaque vague $y$ (avec $y$ entier prenant les valeurs $\{1,2,3,4\}$), est transmis, via le bus d'entrée $e_W$ du quantificateur vectoriel QV à une des entrées appartenant à une première série d'entrées $e_{11}$ à $e_{n1}$ des modules $QV_1$ à $QV_n$. Le vecteur $X_i$ à coder est transmis, pour sa part, à chacune des entrées d'une seconde série d'entrées $e_{12}$ à $e_{n2}$ de ces mêmes modules $QV_1$ à $QV_n$. Chaque module comporte aussi deux sorties distinctes, $S_{Q11}$ à $S_{Qn1}$ et $S_{Q12}$ à $S_{Qn2}$, respectivement. Les sorties de la première série sont connectées à un premier bus de sortie $B_{sbn}$ et les sorties de la seconde série sont connectées à un second bus de sortie $B_F$.

Comme il le sera explicité ci-après plus en détail, en relation avec le chronogramme de la figure 7, chaque module lève un drapeau ou "flag" selon la terminologie anglo-saxonne couramment utilisée. Ce drapeau, après une opération logique prenant en compte la distance du module, est transmis sur le bus $B_{snb}$. Le quantificateur vectoriel procède par élimination des modules élémentaires, selon le processus qui a été décrit en relation avec la figure 5. Un module particulier $QV_n$ qui a trouvé une distance plus petite que les autres modules va les éliminer. Ces modules vont abaisser leurs drapeaux. Le dernier drapeau qui reste levé désigne le module qui a trouvé le vecteur $Wiy$ d'une vague déterminée $y$ le plus proche, par exemple la vague No 1.

Afin de traiter d'autres vagues de 16 vecteurs du dictionnaire DICO, on mémorise dans un registre le complément à "1" de la plus courte distance trouvée lors des vagues précédentes. Ce registre figure sous la référence $M_D$ sur la figure 6. Il reçoit sur une entrée $S_{e1}$ la sortie d'un circuit logique CL effectuant la fonction logique "OU" des signaux présents sur le bus $B_{sbn}$. Le signal sur la sortie de ce circuit est transmis à tous les modules $QV_n$, sur une troisième entrée de ces modules. Comme il le sera décrit de façon plus détaillée ci-après, chacun des modules élémentaires de quantification $QV_1$ à $QV_n$ comprend notamment un comparateur. Ce sont ces comparateurs qui reçoivent le signal présent sur la sortie $S_{e1}$ et génèrent les signaux sur les sorties $SQ_{11}$ à $SQ_{n1}$ et $SQ_{12}$ à $SQ_{n2}$, respectivement. On associe également un comparateur $C_{MD}$ au registre $M_D$. Celui-ci reçoit en entrée le signal présent sur la sortie $S_{MD}$ du registre $M_D$ et sur la sortie Sel, et génère des signaux de sortie sur deux sorties $S_{M1}$ et $S_{M2}$, reliées respectivement aux bus $B_{sbn}$ et $B_F$.

Par ces dispositions, le processus d'élimination concerne également le registre $M_D$. Il est traité exactement comme un module élémentaire de quantification. Il peut donc éliminer les 16 autres modules élémentaires s'il contient la distance binaire la plus courte. Il peut aussi se faire éliminer si un vecteur du dictionnaire DICO de la vague suivante est meilleur que les précédents. On y enregistre alors la nouvelle distance la plus courte.

Les drapeaux restants et le nombre de vagues traitées permettent de trouver l'adresse dans le dictionnaire DICO du vecteur $W_i$ le plus proche du vecteur d'entrée $X_i$. Cette opération est réalisée par le calculateur d'adresse CA. Celui-ci compte le nombre de vagues de vecteurs $W_i$, encode l'adresse du vecteur le plus proche dans une vague et enregistre l'adresse du meilleur vecteur de toutes les vagues. Le codage de l'adresse peut s'effectuer selon la configuration décrite en relation avec la figure 3. Le mot d'adresse $AD_{Wi}$ comprend un numéro de vague $No_{Va}$ et un numéro de vecteur $No_{Wi}$, chacun étant codé, dans l'exemple illustré, sur quatre bits.

En cas d'égalité de distance entre le vecteur d'entrée $X_i$ et des vecteurs du dictionnaire, une priorité peut être donnée, dans l'encodage, au premier vecteur dans une vague et à la première vague dans le dictionnaire DICO.

La figure 7 est un chronogramme explicitant le processus de recherche de distance minimale qui vient d'être décrit.

Sur la partie supérieure de la figure 7 sont représentés les signaux $Z_{in}$ représentant l'inverse logique des distances $D_n$ calculées par les modules élémentaires de quantification $QV_n$. Sur la partie intermédiaire de cette figure est représenté l'état des drapeaux $F_{in}$. Au début du cycle, tous les drapeaux sont levés. Conformément à ce qui a été décrit en relation avec la figure 5, lorsque le quantificateur QV peut prendre une décision, l'un des modules élémentaire de quantification est éliminé et son drapeau est "abaissé" dans l'exemple décrit, c'est le module No 2 qui est le premier éliminé. En fin de vague, seul reste en lice le module No 3, le drapeau $F_{i3}$ restant seul levé (signal $F_{i3}$ haut, c'est-à-dire dans l'exemple décrit au "1" logique). le signal du bas représente l'inverse logique de la somme des distances minimales $\Sigma Z_i = \overline{\text{Distance min}}$. Les signaux $F_{in}$ sont transmis sur le bus $B_F$ et les signaux $Z_{in}$ sur le bus $B_{Sbn}$. Les parties hachurées des signaux de la figure 7 mettent en évidence les modules élémentaires de quantification $QV_n$ éliminés. Les flèches mettent en évidence la distance minimale trouvée, D = 180, en valeur décimale, dans l'exemple illustré, et le module correspondant No 3 (drapeau $F_{i3}$). Comme le vecteur $W_i$ associé au module No 3 et son adresse sont connus, ainsi que le numéro de vague, le calculateur d'adresse CA peut générer le mot d'adresse $AD_{Wi}$ approprié sur la sortie $S_Q$.

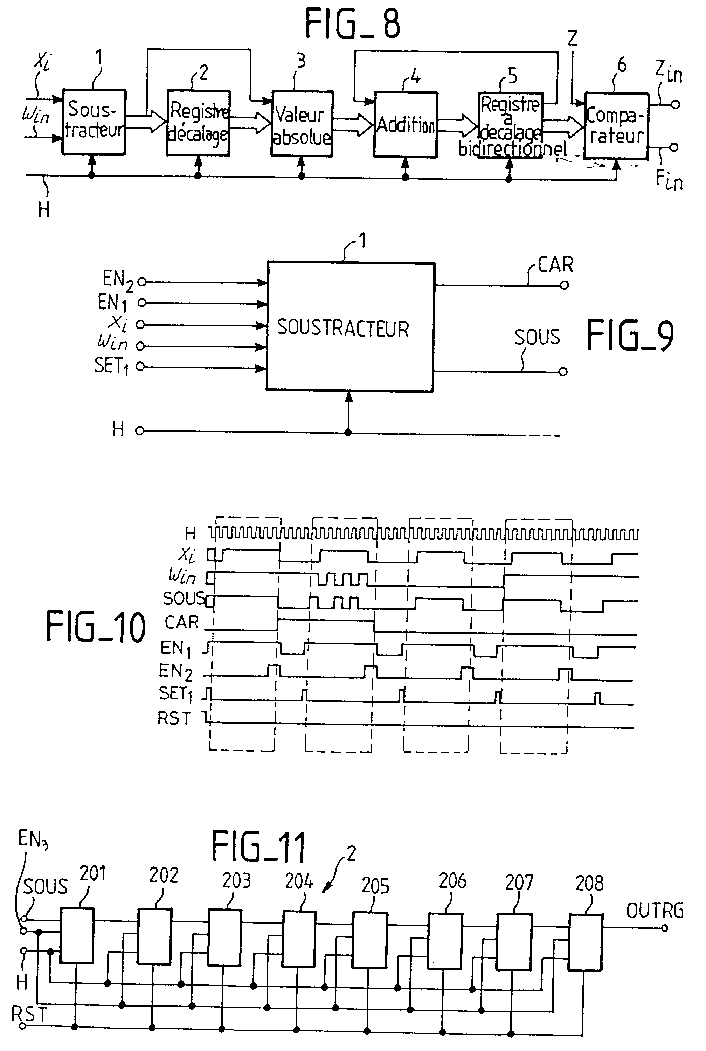

La figure 8 représente de façon schématique un exemple de réalisation possible d'un module quantificateur élémentaire $QV_n$. Chacun de ces modules $QV_n$ reçoit sur une première entrée le vecteur d'entrée $X_i$ à coder et l'un des vecteurs $W_{in}$ du dictionnaire DICO associé à ce module No n, par exemple l'un des 16 vecteurs de ce dictionnaire, s'il n'y a qu'une vague de vecteurs $W_i$, ou l'un des 16 vecteurs d'une des quatre vagues successives, dans l'exemple décrit.

Chaque module comprend, disposés en cascade, un soustracteur 1, un registre à décalage 2, un calculateur de valeur absolue 3, un additionneur 4, un registre à décalage bidirectionnel 5 et un comparateur 6 dont les deux sorties génèrent les signaux respectifs $Z_i$ et $F_i$ déjà décrits, et aussi nommés $SQ_{i1}$ et $SQ_{i2}$, respectivement. La logique est du type séquentiel, synchronisée sur les temps de bit : les vecteurs d'entrée $X_i$ et les vecteurs du dictionnaire sont présentés sous forme série. Aussi un signal d'horloge H est distribué à tous les circuits 1 à 6. Les modules $QV_n$ ont une structure du type "pipe-line", avec un flux continu de données.

Dans l'exemple décrit, le registre à décalage 2 a une profondeur de 8 bits et le registre à décalage bidirectionnel 5 une profondeur de 12 bits. Naturellement, un grand nombre de liaisons spécialisées sont prévues entre les circuits. Pour des raisons de simplicité, on n'a représenté que l'essentiel nécessaire pour la bonne compréhension de l'invention.

Comme il a été indiqué, chaque module élémentaire de quantification $QV_n$ prend en charge la comparaison entre le vecteur d'entrée $X_i$ à coder et l'un des vecteurs $W_i$ du dictionnaire DICO. Les circuits 1 à 6 effectuent successivement les opérations suivantes : différence, en 1, entre les coordonnées des vecteurs $X_i$ et $W_i$; calcul de la valeur absolue, en 3, de ces différences et somme, en 4, de ces valeurs absolues.

Le résultat est donc la distance entre le vecteur d'entrée $X_i$ et le vecteur $W_{in}$ associé au module du dictionnaire DICO. Ce résultat est stocké dans le registre à décalage bidirectionnel 5. Le processus se termine par la comparaison des distances entre modules. A cette fin, tous les modules $QV_n$ reçoivent, via le bus $B_{sbn}$ et le circuit CL (figure 6) le signal Z, transmis à l'une des entrées du comparateur 6. Z est au "1" logique, dans l'exemple décrit, si au moins l'un des comparateurs des autres modules a trouvé un bit nul au cours du processus de comparaison des distances. Si Z est à "1" et que le bit qui rentre dans le comparateur 6 n'est pas nul, alors la distance que traite ce comparateur est supérieure aux autres. On peut donc l'éliminer, selon l'enseignement du procédé de l'invention (figure 5). Le comparateur 6 sera décrit de façon plus détaillée ci-après.

Les coordonnées sont codées, dans l'exemple décrit, sur 8 bits signés (-128 à +127), présentées en série à l'entrée du soustracteur 1 ("LSB" en premier et "MSB" et signe en dernier). Le registre à décalage 2 de 8 bits permet d'attendre le bit de signe et de calculer alors la valeur absolue du résultat, sur 8 bits non signés (0 à +255).

L'additionneur 4 est rebouclé sur lui-même par le registre à décalage 5 de 12 bits. permettant de stocker la somme des valeurs absolues ("LSB" en premier. Les 12 bits (0 à +4095) permettent de travailler avec des vecteurs d'un maximum de 16 coordonnées. le résultat final est la distance entre les vecteurs sur 12 bits ("LSB" en premier).

Cependant la comparaison des distances s'effectue du bit de plus fort poids ("MSB") au bit de plus faible poids ("LSB"). C'est la raison pour laquelle le registre 5 est bidirectionnel.

Le comparateur 6 effectue les comparaisons des distances entre les 16 modules quantificateurs élémentaires $QV_n$ suivant les étapes décrites en relation avec la figure 5. Les deux sorties du comparateur 6 génèrent, d'une part, le signal de drapeau $F_{in}$ et, d'autre part, le signal $Z_i$. Ce dernier représente un signal de détection de bit à zéro. Le signal de drapeau $F_{in}$ sert à désigner le module quantificateur élémentaire $QV_n$ ayant trouvé la distance minimale, comme le chronogramme de la figure 6 l'a illustré.

Le signal Z indique que d'autres modules élémentaires ont un bit nul dans leur distance, ce qui déclenchera l'élimination éventuelle du module $QV_n$ et l'abaissement du drapeau $F_{in}$.

La comparaison concerne également le registre $M_D$ contenant la distance la plus petite des vagues précédentes, quand plusieurs vagues successives sont traitées, selon le mode de réalisation préféré de l'invention. A cette fin, comme il a été indiqué, ce registre $M_D$ comprend des circuits munis d'un comparateur, de façon tout à fait similaire aux modules quantificateurs élémentaires $QV_n$. Il génère donc aussi un signal de drapeau (sortie $S_{M2}$) et un signal $Z_i$ (sortie $S_{M1}$).

Le flux continu des données à travers les modules $QV_n$ oblige à respecter le rythme de l'opération la plus lente, dans le cas présent celui de l'addition sur 12 bits qui nécessite douze périodes d'horloge. Il s'ensuit que, dans l'exemple décrit, les coordonnées des vecteurs étant composées de 8 bits, celles-ci devront être séparées par 4 bits non significatifs.

La comparaison finale exige également un intervalle de temps déterminé. On ne dispose de l'adresse du vecteur le plus proche que 30 périodes d'horloge après le dernier bit de la dernière coordonnée des vecteurs de la dernière vague.

Les différents circuits constituant chaque quantificateur élémentaire $QV_n$ et les circuits du registre $M_D$ ainsi que ses éléments associés $C_{MD}$, peuvent être réalisés par toute technologie appropriée, à la portée de l'Homme de Métier. On utilisera de façon avantageuse des circuits intégrés ou des associations de circuits intégrés disponibles dans le commerce ou, au contraire, des circuits réalisés à la demande, du type "ASIC" par exemple.

Aussi on ne va décrire de façon détaillée les différents composants du quantificateur vectoriel QV que dans la mesure où cette description est nécessaire à une compréhension plus complète de l'invention. On s'attachera surtout à décrire les signaux nécessaires au bon fonctionnement des circuits du quantificateur vectoriel QV et permettant le bon déroulement du procédé de l'invention.

Le soustracteur 1 est représenté schématiquement sur la figure 9.

Il est de type tout à fait classique. Les signaux nécessaires au bon fonctionnement de celui-ci sont les suivants :

- le signal RST est un signal asynchrone de remise à zéro des retenues CAR;
- le signal $EN_1$ est un signal de validation de la mémorisation de la retenue CAR. Il doit être au "1" logique au moins pendant 1 bit et les 8 bits de coordonnées (en pratique, ce signal peut être laissé à "1");
- Le signal $SET_1$ sert à positionner la retenue CAR à "1" avant le premier bit. Il doit être mis à "1" pendant la période d'horloge qui précède l'arrivée du premier bit de chaque coordonnée;
- Les signaux $X_i$ et $W_{in}$ sont les données d'entrée représentant le vecteur d'entrée et le vecteur du dictionnaire DICO, dont les bits sont présentés au format série en partant du bit de plus faible poids ("LSB");
- Le signal $EN_2$ valide la retenue. Il doit être mis à "1" pour le dernier bit de chaque coordonnée;
- Le signal CAR représente la retenue. C'est le signe du résultat. CAR est disponible à la fin de la soustraction pour calculer la valeur absolue. CAR doit être positionné à "1" avant de démarrer le calcul; et
- Le signal SOUS est le résultat de la soustraction $[X_i - W_{in}]$ sur 8 bits format série, le bit de plus faible poids en premier. Il n'y a pas de délais (en dehors du temps de propagation propre aux circuits constituant le soustracteur 1) entre l'entrée des données et la sortie du résultat.

Naturellement, le soustracteur reçoit le signal d'horloge H, cadencé sur le temps de bit. Les circuits d'élaboration de ces signaux de commande et leur agencement ne posent aucun problème particulier et sont du domaine de la compétence de l'Homme du Métier et il est inutile de les décrire plus avant.

La figure 10 est un chronogramme illustrant le fonctionnement du soustracteur 1. Les signaux portent les mêmes références que sur la figure 9. Dans l'exemple illustré, on a réalisé quatre soustractions successives de 8 bits signés, correspondant à quatre vagues de vecteurs $W_i$ du dictionnaire DICO. A titre d'exemple, les soustractions illustrées par la figure 10 sont les suivantes :

11111110 (-2) - 11111111 (-1) = 11111111 (-1 sur 8 bits) avec retenue à 1
01111110 (+126) - 01010101 (+85) = 00101001 (+41) retenue à 0
01111110 (+126) - 00000000 (+0) = 01111110 (+126) retenue à 0
01111110 (+126) - 11111111 (-1) = 01111111 (+127) retenue à 0

La figure 11 illustre un exemple de registre à décalage 2 utilisable dans le cadre de l'invention. Le registre à décalage 2, de façon classique, comprend huit bascules D, 201 à 208, disposées en cascade.

Le registre 2 reçoit, sur une première entrée de la première bascule 201, le signal SOUS, résultat de la soustraction et généré par le soustracteur 1. Le signal RST est asynchrone et remet à zéro le contenu du registre. Il a été précédemment décrit. Il est transmis à toutes les bascules (entrée de remise à zéro). Un signal $EN_3$ valide la propagation des données le long du registre 2. Il doit être à l'état "1" logique avant le processus de décalage, dans l'exemple avec le type de logique choisi. Il est également transmis sur une seconde entrée de toutes les bascules. Enfin le signal d'horloge H est transmis aux entrées prévues à cet effet de toutes les bascules.

Sur sa sortie, la dernière bascule 208 délivre un signal OUTRG. Ce denier est égal au signal SOUS après un décalage de huit périodes d'horloge.

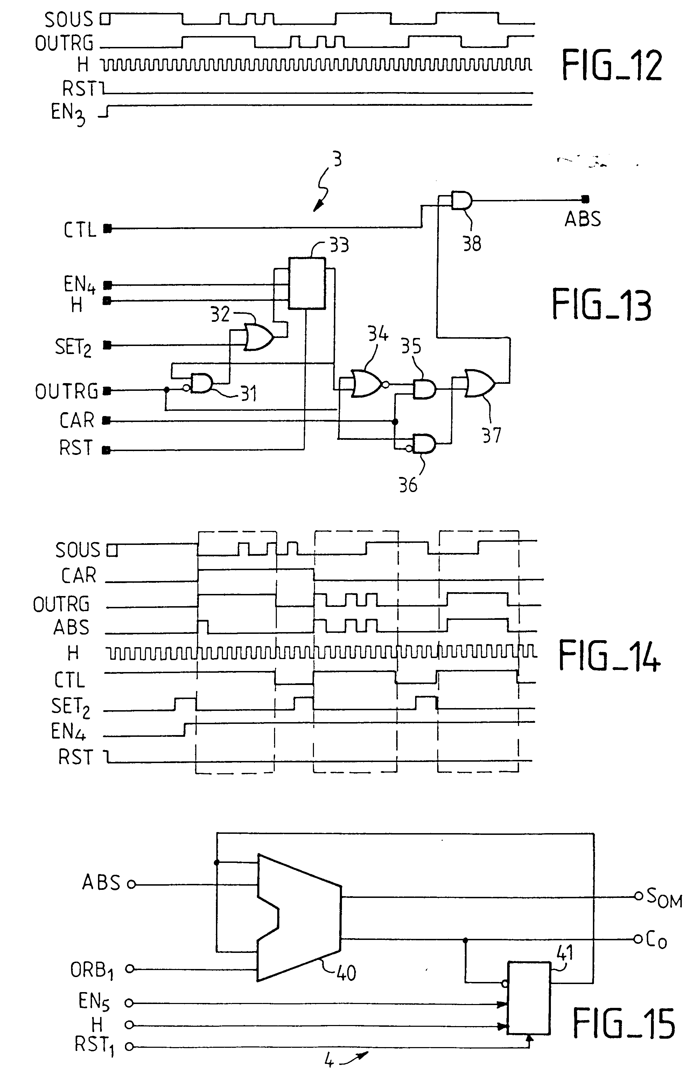

Le chronogramme de la figure 12 illustre ce processus. Les signaux représentés sur ce chronogramme portent les mêmes références que ceux de la figure 11.

La figure 13 illustre un exemple de circuit 3 calculateur de valeur absolue utilisable dans le cadre de l'invention.

Les signaux nécessaires au bon fonctionnement du calculateur de valeur absolue sont les suivants :

- Le signal de remise à zéro RST qui est asynchrone et transmis à l'entrée de remise à zéro de la bascule 33;
- Le signal d'horloge H transmis à l'entrée d'horloge de cette même bascule;

- Le signal OUTRG transmis sur l'entrée de donnée des circuits 3, c'est-à-dire sur l'entrée inverseuse d'une porte ET 31, l'une des entrées d'une porte OU EXCLUSIF 34 et l'entrée non inverseuse d'une porte ET 36; et
- Le signal CAR est transmis à l'entrée inverseuse d'une porte ET 36 et à l'une des entrées d'une porte ET 35. Lorsque ce signal CAR est égal à "1" logique, il entraîne la complémentation à 2 des données; Tous ces signaux ont déjà été décrits en relation avec les figures 9 à 12. En outre les signaux suivants sont nécessaires :
- Le signal $EN_4$ qui est un signal de validation de la propagation du calcul d'un bit à l'autre (calcul du complément à 2). IL est transmis à l'une des entrées de la bascule 33;
- Le signal $SET_2$, transmis à l'une des entrées de la bascule 33 via une porte OU 32 et qui sert à positionner cette bascule au "1" logique avant l'arrivée du premier bit (calcul du complément à 2);
- Le signal CTL qui valide la sortie s'il est au "1" logique. Il sert à étendre le résultat sur 12 bits en maintenant la sortie au "0" logique pendant la période de 4 bits supplémentaires. Il est transmis à l'une des entrées de la porte ET 38.

Le signal de sortie du circuit 3 est le signal ABS égal à la valeur absolue du signal d'entrée. Il n'y a pas de délais entre l'entrée et la sortie, au temps de propagation près au travers des diverses portes.

Pour compléter la description, la sortie du circuit logique ET 31 est reliée à l'entrée du circuit logique OU 32, la sortie "vraie" de la bascule 33 est rebouclée sur l'entrée non inverseuse de la porte ET 31 et, de plus, est reliée à la seconde sortie de la porte OU-EXCLUSIF 34, la sortie inversée de celle-ci est reliée à la seconde entrée de la porte 35, les sorties des portes 35 et 36 sont reliées chacune à l'une des deux entrées d'une porte OU 37 et la sortie de celle-ci est reliée à la seconde entrée de la porte ET 38, étage de sortie du circuit 3.

Le chronogramme de la figure 14 illustre trois exemples de calcul de la valeur absolue de signaux d'entrée OUTRG. Les signaux représentés sur cet organigramme portent les mêmes références que sur la figure 13.

Les calculs effectués sont les suivants :

OUTRG = SOUS décalé de 8 bits afin de disposer en temps utile de la retenue CAR
OUTRG = 11111111 et CAR = 1 (-1) donc ABS = 00000001 (+1)
OUTRG = 00101001 et CAR = 0 (+41) donc ABS = 00101001 (+41)
OUTRG = 01111110 et CAR = 0 (+126) donc ABS = 01111110 (+126)

L'additionneur 4, représenté de façon plus détaillée par la figure 15, est d'un type classique. Il comprend des circuits logiques combinatoires 40, générant un signal somme SOM et un signal retenu CO, et un registre d'enregistrement de la retenue constitué une bascule 41. Les signaux à additionner sont, d'une part, le signal ABS provenant du circuit 3 de calcul de la valeur absolue et le signal $ORB_1$, signal de sortie du registre à décalage bidirectionnel 5 qui sera décrit dans ce qui suit. Ce signal est égal au résultat précédemment calculé. Tout au début des calculs, tous les bits de ce signal sont naturellement égaux à zéro.

Le registre de retenue 41 reçoit, sur une entrée de remise à zéro un signal $RST_1$, qui remet à zéro la bascule avant de commencer le calcul de la somme, le signal d'horloge H sur l'entrée d'horloge de la bascule et un signal $EN_5$ de validation de propagation de la retenue.

Le signal en sortie "vraie" de la bascule 41 est rebouclé sur les entrées des circuits de calcul de la somme SOM et de la retenue CO. Le résultat de l'addition est fourni sans délai, au temps de propagation près. Normalement, le signal de retenue CO n'est pas utilisé à l'extérieur des circuits 3.

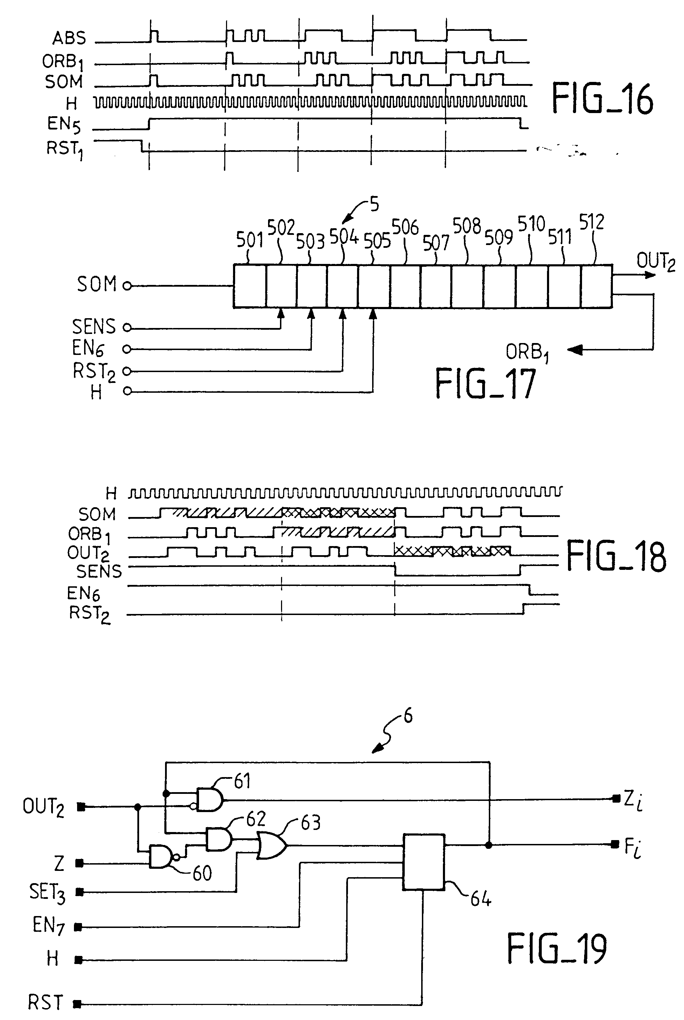

Le chronogramme de la figure 16 est un exemple de cinq additions particulières. Les signaux représentés sur ce chronogramme portent les mêmes références que sur la figure 15. L'additionneur travaille sur 12 bits puisqu'il reçoit la sortie du registre à décalage bidirectionnel 5. Le processus d'addition est le suivant :

$$000000000000 \ (0) \qquad + 000000000000 \ (1) = 000000000001 \ (1)$$
$$+ 000000101001 \ (41) = 000000101010 \ (42)$$
$$+ 000001111110 \ (126) = 000010101000 \ (168)$$
$$+ 000001111111 \ (127) = 000100100111 \ (295)$$
$$+ 000001111111 \ (127) = 000110100110 \ (422)$$

La somme maximale que l'on peut atteindre dans l'additionneur est (cas des vecteurs de 16 coordonnées) :
$$16 \times [(-128) - (+127)] = 111111110000 \ (4080)$$
$$16 \times [(+127) - (-128)] = 111111110000 \ (4080)$$

Il n'y a donc jamais de retenue à la fin du calcul sur 12 bits. On pourra donc se passer, dans ce cas, de remettre à zéro à l'aide de $RST_1$ après chaque calcul.

Le registre à décalage bidirectionnel 5 a un double rôle : d'une part il accumule la somme des distances par un rebouclage sur l'additionneur, comme précédemment décrit, d'autre part, il permet la sortie du résultat, dans l'ordre inverse d'arrivée, pour permettre la comparaison.

Comme illustré de façon schématique par la figure 17, de façon classique, le registre à décalage 5 comprend 12 bascules 501 à 512 en cascade, reliées entre elles à l'aide d'un réseau de portes logiques permettant une propagation avant ou arrière des bits du signal d'entrée, selon l'état logique d'un signal de commande particulier.

Le signal d'entrée est le signal SOM généré par l'additionneur 4.

Le registre à décalage bidirectionnel reçoit également un signal $RST_2$ de remise à zéro de l'ensemble des bascules 501 à 512, le signal d'horloge H, un signal de validation $EN_6$ de propagation des bits de données et un signal de commande de sens SENS, déterminant le sens de propagation. Dans l'exemple précis décrit, ce signal est au "1" logique pour le sens de l'accumulation des données et au "0" logique pour la sortie en marche arrière des données.

Le signal de sortie $ORB_1$ correspond à la marche avant des données, avec un retard de 12 bits (périodes d'horloge) et est retransmis à l'une des entrées de l'additionneur 4, comme il a été précédemment décrit.

Le signal $OUT_2$ correspond à la sortie en marche arrière des données, partant du bit de plus fort poids ("MSB"). Ce signal est transmis au comparateur 6, comme décrit ci-après.

La figure 18 est un chronogramme illustrant la marche des signaux dans le registre à décalage bidirectionnel 5. Les signaux illustrés par ce chronogramme portent les mêmes références que sur la figure 17. Tant que le signal SENS est au "1" logique, il y a propagation avant des données. On remarque que la séquence représentée par le signal SOM, soit 110010010000 (hachures simples sur le chronogramme) se retrouve sur le signal $ORB_1$ décalée de douze périodes d'horloge H. Elle est retransmise à l'additionneur 4. La séquence suivante du signal SOM est 110010110000. Destinée au comparateur, elle est retransmise par le signal $OUT_2$ en marche arrière, soit 000011010011 (hachure double sur le chronogramme), car le signal SENS est passé à l'état "0" logique.

Le comparateur 6 a également un double rôle. Le premier est de gérer un drapeau qui sert à indiquer qu'il a détecté la plus petite distance. Le second rôle est de détecter les bits nuls dans la distance qu'il traite. Pendant le processus de comparaison, cette information est transmise à l'ensemble des comparateurs pour les éliminer éventuellement.

La figure 19 illustre un exemple d'architecture de comparateur élémentaire 6 pouvant être mis en oeuvre dans le cadre de l'invention.

Les signaux nécessaires au bon fonctionnement de ce circuit sont les suivants :
- Le signal RST est un signal de remise à zéro transmis à l'entrée de remise à zéro d'une bascule 64;
- Le signal d'horloge H qui est transmis à l'entrée d'horloge de cette même bascule 64;
- Le signal $SET_3$ qui est un signal destiné à forcer au "1" logique la bascule du drapeau $F_i$. Il est transmis à une première entrée de la bascule 64, via une porte logique OU 63;
- Le signal $EN_7$ qui valide la bascule 64 du drapeau $F_i$. Ce signal est transmis sur une seconde entrée de la bascule 64;
- Le signal $OUT_2$, en provenance du registre à décalage bidirectionnel 5, qui représente la distance, bit de plus fort poids en premier ("MSB"). Ce signal est transmis, d'une part à l'entrée inverseuse d'une porte logique ET 61 et à l'une des entrées d'une porte logique NON-ET 60; et
- Le signal Z qui est le signal "détection de zéro" provenant de tous les autres comparateurs des modules de quantification élémentaires $QV_n$. Il est transmis à la seconde entrée de la porte NON-ET 60;
  Les signaux RST, H et $OUT_2$ ont été précédemment décrits.
  En sortie, le comparateur 6 génère deux signaux :
- Le signal $Z_i$, présent sur la sortie de la porte logique ET 61, ou signal d'information de détection d'un bit nul dans le signal de distance $OUT_2$ entrant si le drapeau n'est pas abaissé; et
- Le signal de drapeau $F_i$ associé au comparateur particulier $QV_n$ et présent sur la sortie "vraie" de la bascule 64.

Pour compléter la description, la sortie véhiculant le signal $F_i$ est rebouclée, d'une part, sur l'entrée non inverseuse de la porte logique ET 61, et d'autre part, sur une première entrée d'une porte ET 62, la sortie de la porte logique NON-ET 60 est connectée à la seconde entrée de la porte logique ET 62 et la sortie de celle-ci est connectée à la seconde entrée de la porte logique OU 63.

Le processus de comparaison se déroule selon les étapes décrites en relation avec la figure 5. les modules de quantification élémentaires $QV_n$ sont synchronisés entre eux pendant ce processus. Les distances sont comparées entre elles bit à bit, en débutant par le bit de plus fort poids ("MSB").

Les signaux $Z_i$ de toutes les sorties des comparateurs des modules de quantification élémentaires $QV_n$ sont combinés en un OU logique (porte logique CL : figure 6) pour former le signal Z en entrée, ce signal Z étant transmis à tous les comparateurs 6. Il s'ensuit que Z est au "1" logique si l'un au moins des comparateurs a trouvé un bit nul au cours du processus de comparaison des distances.

Si Z est au "1" logique et que le bit entrant n'est pas nul, alors la distance que traite ce comparateur 6 est supérieure aux autres. Il peut donc être éliminé.

Avant la comparaison, pour chaque module, le drapeau $F_i$ est levé ("1" logique), ce en utilisant le signal $SET_3$. Tant qu'il reste au "1" logique, le module de quantification élémentaire $QV_n$ concerné reste en course dans la recherche de la plus petite distance. Il bascule au "0" logique si l'un des comparateurs 6 des autres modules voit une distance plus petite.

Dès que le drapeau Fi est retombé, le module correspondant est éliminé. La suite du processus de comparaison ne concerne plus ce module. $Z_i$ n'est plus transmis et reste au "0" logique. Ainsi les autres comparateurs ne sont pas perturbés dans la suite de la comparaison.

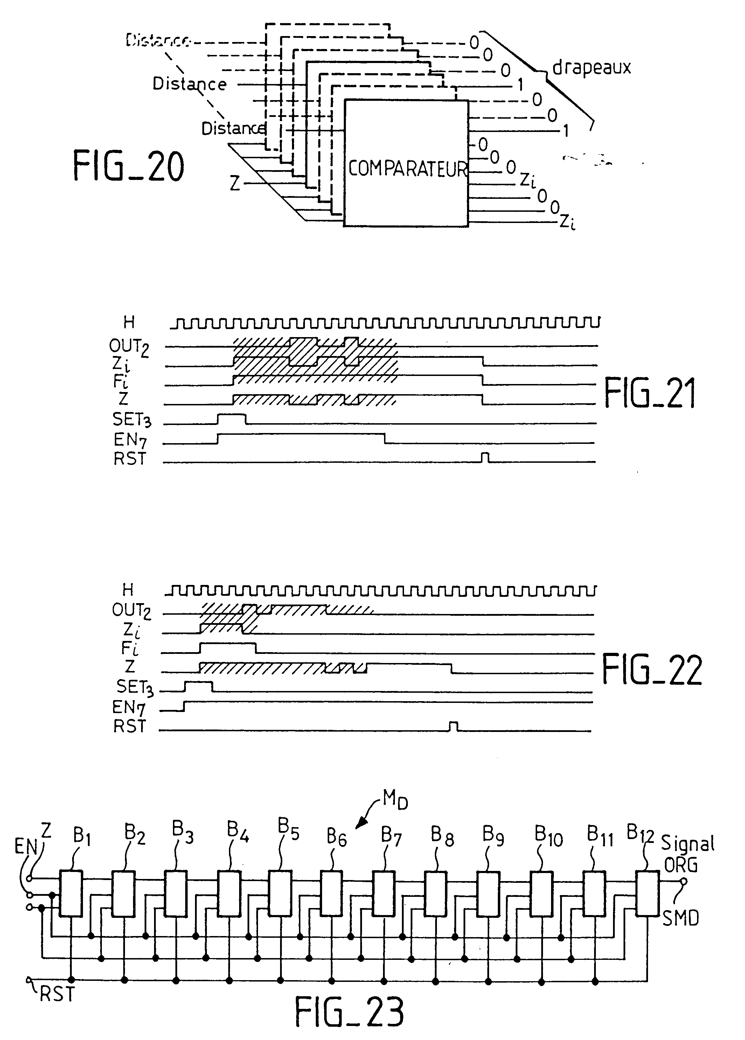

La figure 20 représente schématiquement l'ensemble des comparateurs du quantificateur vectoriel QV et illustre le processus d'élimination progressive de ceux-ci. Sur cette figure, les comparateurs en traits pointillés sont éliminés, le drapeau $F_i$ correspondant est au "0" logique, ainsi que le signal $Z_i$.

Pour fixer les idées, les chronogrammes des figures 21 et 22 illustrent deux exemples de comparaisons de distances. Les signaux représentés portent les mêmes références que sur la figure 20.

On remarque que, sur le chronogramme de la figure 21, la distance 000011001000 véhiculée par le signal $OUT_2$ a été plus petite que les autres distances. Il s'ensuit que le drapeau $F_i$ est resté au "1" logique pendant tout le processus de comparaison. $Z_i$ a pour valeur 111100110111, ce qui est l'inverse logique de la distance véhiculée par le signal d'entrée $OUT_2$.

Sur le chronogramme de la figure 22, une distance plus courte a été trouvée dès le quatrième bit, ce qui a provoqué l'abaissement du drapeau $F_i$.

On remarque que Z transmet l'inverse logique de la distance la plus courte. Jusqu'à présent, on a considéré implicitement qu'il n'y avait qu'une seule vague de vecteurs $W_i$ à traiter. Selon un mode de réalisation préféré, on traite plusieurs vagues successives de vecteurs, comme il a déjà été indiqué.

Il convient donc, après chaque vague, de conserver en mémoire la distance du vecteur le plus proche trouvée pendant le traitement de cette vague. Cette disposition permet de comparer les distances de chaque nouvelle vague à cette distance minimale.

Pour ce faire, il suffit de stocker le signal

$$Z = \sum_i Z_i = \overline{\text{Distance min}}$$

dans un registre à décalage classique $M_D$, comme illustré par la figure 23. Ce registre $M_D$ est constitué de 12 bascules en cascade $B_1$ à $B_{12}$. Il reçoit les signaux suivants :
- Le signal de remise à zéro RST transmis aux entrées de remise à zéro de toutes les bascules $B_1$ à $B_{12}$;
- le signal d'horloge H transmis aux entrées d'horloge de ces mêmes bascules;
- Le signal de validation EN qui valide la propagation des données dans le registre à décalage $M_D$; et
- Le signal Z représentant les données d'entrée (véhiculé par la liaison $S_{e1}$ : figure 6);

Par la sortie $S_{MD}$, le signal ORG est transmis au circuit $C_{MD}$ (figure 6) qui comprend, comme les quantificateurs élémentaires $QV_n$, un comparateur. Ce circuit sera détaillé dans ce qui suit. Ce signal est décalé de 12 périodes d'horloge par rapport au signal d'entrée Z.

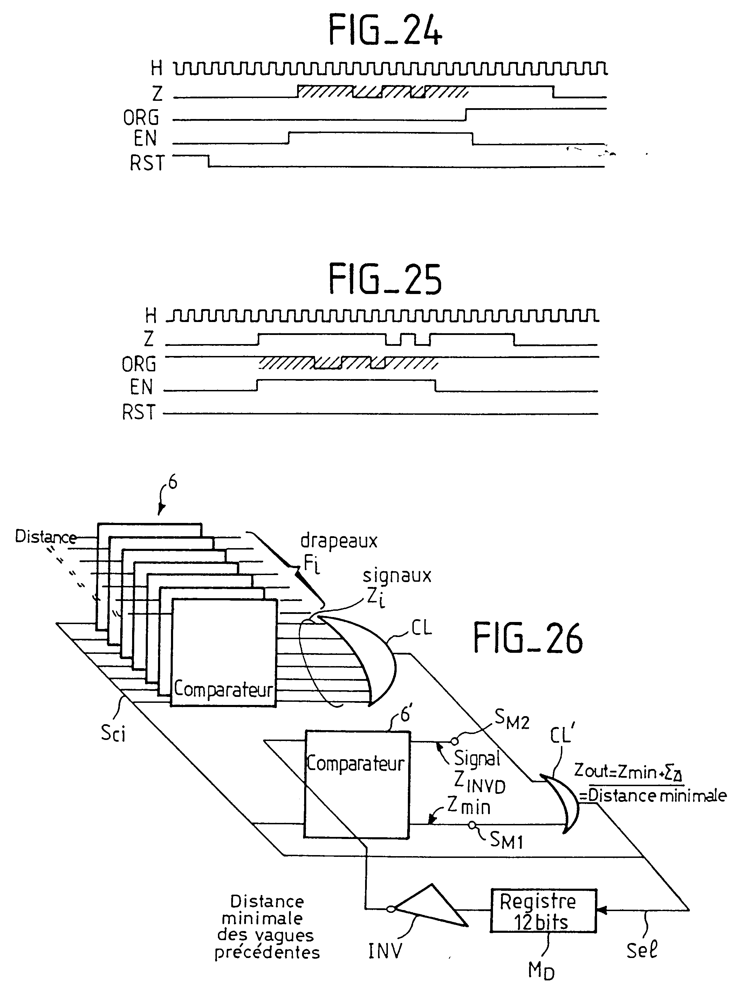

Le chronogramme de la figure 24 illustre, pour un exemple particulier, le processus de mémorisation d'une distance véhiculée par le signal Z et représentée par la séquence 111100110111. Le stockage s'effectue sous la commande du signal de validation EN. Au préalable, le registre $M_D$ a été remis à zéro par le signal RST.

L'organigramme de la figure 25 illustre le processus de sortie (signal ORG) de cette même séquence hors du registre $M_D$, toujours sous la commande du signal de validation EN.

La figure 26 illustre les circuits complets de comparaison, incluant le circuit de comparaison des circuits $C_{MD}$ (figure 6) : comparateur 6'. L'inverse de la distance minimale est stockée après chaque vague dans le registre à décalage $M_D$ de profondeur 12 bits. La porte logique CL effectue un premier OU logique de tous les signaux $Z_i$ générés par les comparateurs élémentaires 6. Une deuxième porte logique CL' effectue un OU logique du signal de sortie de la porte CL et du signal $Z_{min}$, généré par le comparateur 6'. Ce signal est en tout point similaire aux signaux $Z_i$. Une seule porte OU pourrait d'ailleurs être utilisée. Le signal de sortie de la porte CL' est égal à : $Z_{out} = Z_{min} + \Sigma Z_i = \overline{\text{Distance minimale}}$. Ce signal est transmis à l'entrée Z de tous les comparateurs 6, y compris le comparateur 6', d'une part, et à l'entrée du registre à décalage 12 bit $M_D$, d'autre part.

Ces dispositions permettent de comparer la distance minimale trouvée dans l'ensemble des vagues aux nouvelles distances calculées pour une nouvelle vague. Le processus d'élimination des plus grandes distances concerne également cette distance, comme il a été indiqué précédemment. Le comparateur 6' est en tout point identique aux comparateurs 6. Il est donc inutile de le redécrire. Comme le registre à décalage $M_D$ contient l'inverse de la distance minimale des vagues précédentes, on utilise un inverseur logique INV intercalé entre la seconde entrée du comparateur (entrée du signal distance) et la sortie du comparateur $M_D$.

A la remise à zéro, il contient la valeur 000000000000 qui correspond à une distance jamais atteinte, c'est-à-dire à la distance 111111111111 (4095) qui sera systématiquement éliminée dès la première vague de vecteurs.

Le drapeau résultant, référencé $Z_{INVD}$, est traité différemment des 16 autres. S'il est abaissé, cela signifie qu'un vecteur est plus proche dans la vague qui vient d'être traitée. Ce signal commande donc la mémorisation d'une nouvelle adresse du meilleur vecteur du dictionnaire DICO.

Comme il a été indiqué, l'encodage des vecteurs d'entrée a pour but de réduire l'information apportée par l'ensemble des drapeaux en cours de quantification à une donnée simple et finale : l'adresse, dans le dictionnaire DICO, du vecteur $W_i$ le plus proche du vecteur à quantifier $X_i$.

Après chaque vague de vecteurs, chacun des 16 modules élémentaires de quantification $QV_n$ produit un drapeau indiquant le passage d'un vecteur pertinent du dictionnaire DICO. Un dix-septième drapeau concerne la mémoire de la plus petite distance trouvée. Ce dernier drapeau indique que rien de mieux n'a été trouvé dans la vague qui vient de passer. C'est celui-ci qui provoque la mémorisation de l'adresse d'un nouveau vecteur. C'est donc à ce niveau que se décide de la priorité accordée à un vecteur ou à un autre s'ils sont à la même distance binaire du vecteur à quantifier. De façon préférentielle, la priorité est donnée à l'indice la plus faible dans une vague donnée de vecteur et à la première vaque parmi plusieurs. Il s'ensuit que l'on utilise, dans un mode réalisation préféré de l'invention, un encodeur prioritaire et un compteur de vagues.

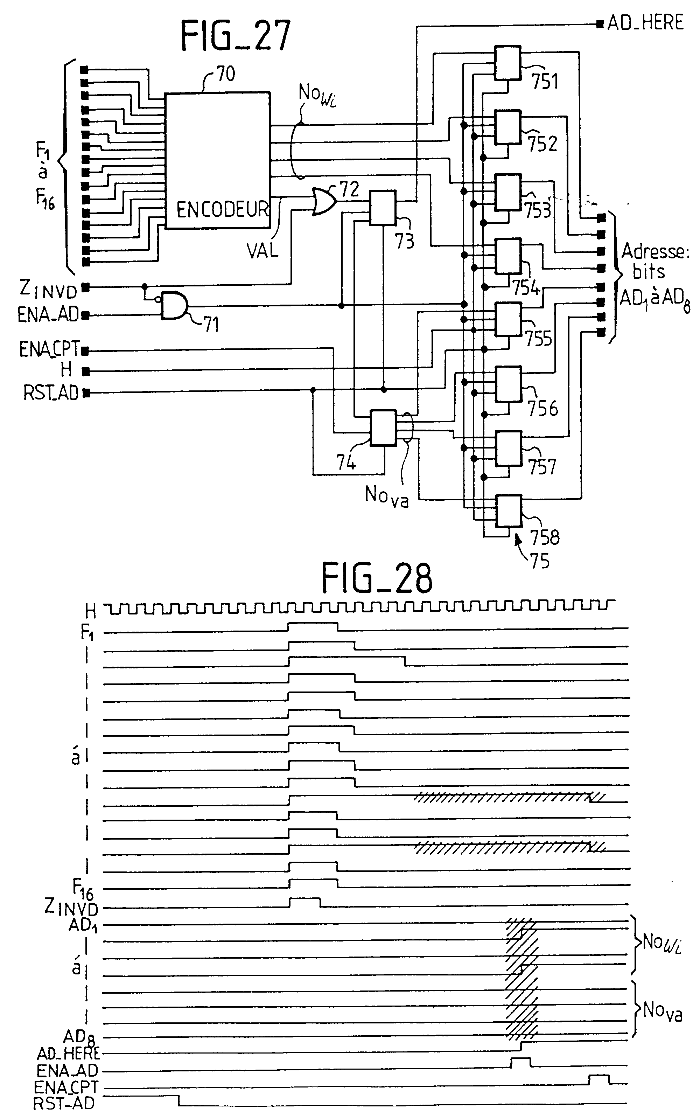

La figure 27 illustre un exemple de réalisation du calculateur d'adresse CA (figure 6). Il comprend un encodeur à priorité 70 recevant les 16 drapeaux $F_1$ à $F_{16}$ à encoder. Ces drapeaux sont générés par les comparateurs élémentaires 6. Cet encodeur 70 peut être réalisé, de façon classique, en logique combinatoire. Dans exemple décrit, il code les 16 drapeaux $F_i$ en un mot binaire de quatre bits. Ces quatre bits représentent le numéro de vecteur dans une vague $No_{Wi}$ (figure 2). De façon accessoire, un signal VAL est dérivé des signaux de drapeaux $F_i$ indiquant qu'au moins un drapeau est à l'état logique "1". Les quatre bits $No_{Wi}$ sont transmis à quatre bascules, 751 à 754, de type "latch" d'un registre de mémoire d'adresses 75, qui en comporte quatre autres, 755 à 758. Un deuxième circuit important du calculateur d'adresse CA est constitué par un compteur 74 dont le but est de compter le nombre de vague. En sortie, il génère un nombre binaire $No_{va}$, également de quatre bits, représentant le numéro de vague, et transmis aux quatre dernières bascules, 755 à 758, pour y être enregistré.

Une porte OU 72 combine le signal VAL généré par le codeur 70 et le signal $Z_{INVD}$ produit par le comparateur 6' (figure 26). La sortie de cette porte logique 72 est transmise à une première entrée d'une bascule 73. Le signal $Z_{INVD}$ et un signal de commande de validation ENA_AD sont transmis, respectivement aux entrées inverseuse et non inverseuse, d'une porte logique ET 71. La sortie de cette porte logique est transmise sur l'entrée de validation de la bascule 73 et de toutes les bascules du registre 75. Il provoque l'écriture de l'adresse dans les bascules du registre 75 et l'écriture du signal en sortie de la porte logique 72, combinaison du signal VAL est du signal $Z_{INVD}$, c'est-à-dire le OU logique de tous les drapeaux. Le signal AD_HERE, en sortie de la bascule 73, indique qu'un vecteur proche a été trouvé.

Le signal ENA_CPT sert à incrémenter le compteur 74 à chaque passage de vague de vecteurs. Il doit être mis au "1" logique pendant une période d'horloge après chaque vague.

Enfin, toutes bascules, 73 et 751 à 758, ainsi que le compteur 74, reçoivent le signal d'horloge H et un signal de remise à zéro RST_AD.

Les signaux binaires sur les sorties des bascules 751 à 758 sont les bits d'adresses $AD_1$ à $AD_8$ du vecteur adresse $AD_{Wi}$ associé au meilleur vecteur $W_i$ du dictionnaire DICO.

La figure 28 est un chronogramme illustrant, sur un exemple particulier, l'encodage d'adresse lors de la première vague de vecteurs, à l'aide des circuits CA qui viennent d'être détaillés.

On observe, sur le chronogramme, le processus d'élimination qui conduit à trouver la distance minimale. $Z_{INVD}$ correspondant au registre de distance minimale est éliminé en premier. Dans l'exemple illustré, ce registre était vide. Ensuite $F_1$, $F_6$, $F_8$, $F_{12}$, $F_{13}$, $F_{15}$ sont éliminés, puis $F_2$, $F_4$, $F_5$, $F_7$, $F_9$, $F_{10}$ et enfin $F_4$. Il reste $F_{11}$ et $F_{14}$ dont les comparateurs 6 correspondants on vu passer la distance la plus petite. Le signal ENA_AD autorise l'écriture de l'adresse en sortie. A l'encodage, on retrouve sur $AD_1$ à $AD_4$ (numéro $AD_{Wi}$ du vecteur $W_i$) la désignation de $F_{11}$, qui a bénéficié de la priorité à l'indice le plus faible. Sur AD5 à AD8, on trouve le numéro de la vague ($No_{va}$): première vague ou vague de valeur zéro. Le signal ENA_CPT permet d'incrémenter le compteur de vague 74.

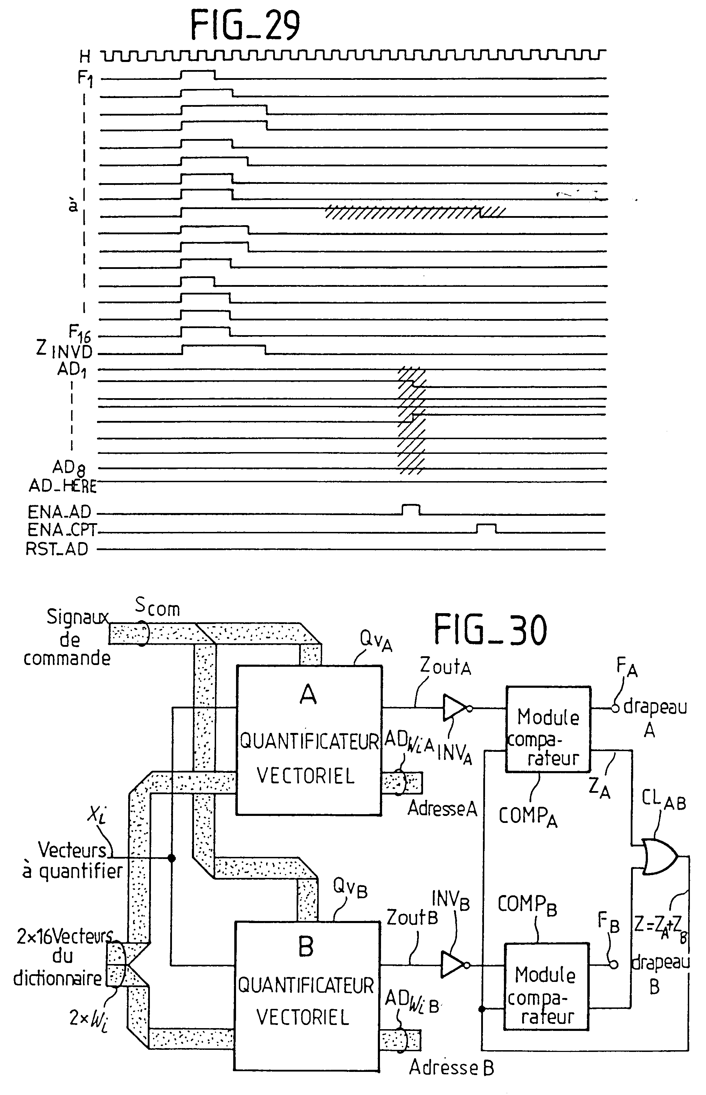

La figure 29 est un chronogramme illustrant l'encodage d'adresse lors d'une deuxième vague. Dans l'exemple illustré, on a supposé qu'un vecteur plus performant que les vecteurs précédents était passé par

$F_{19}$. Le résultat est 18 (en hexadécimal), soit le vecteur 8 de la deuxième vague ou vague codée 1.

Dans l'exemple de réalisation détaillé, le compteur de vagues 74 accepte un maximum de 16 vagues successives. Il est clair que l'invention ne saurait être limitée à cette valeur particulière. On peut facilement augmenter la capacité de ce compteur. Naturellement, le nombre de bits d'adresse doit être augmenté concurremment à l'augmentation de la capacité du compteur.

On peut encore améliorer les caractéristiques de rapidité d'un quantificateur selon l'invention. En effet la vitesse du quantificateur QV est physiquement limitée. On doit prendre en considération les caractéristiques des composants utilisés pour le réaliser : circuits intégrés d'une technologie déterminée. La conception influe également sur les caractéristiques globales : la spécification de chemins critiques permet dans une grande mesure de prévoir et améliorer la vitesse de fonctionnement. Il n'en demeure pas moins vrai, que lorsque tous les paramètres ont été optimisés, il n'est plus possible d'augmenter la vitesse de fonctionnement.

On peut cependant encore augmenter la vitesse de quantification en scindant le dictionnaire DICO en N parties distinctes, ou sous-dictionnaires. Chaque sous-dictionnaire est associé à un quantificateur particulier. Si le nombre de vecteurs $W_i$ du dictionnaire DICO est divisible par N, il s'ensuit alors que le gain en rapidité obtenu est pratiquement N fois celui atteint lorsqu'on utilise un seul quantificateur, avec la même quantité totale de vecteurs $W_i$ naturellement. Chaque vecteur d'entrée $X_i$ est présenté simultanément au N quantificateurs. Les signaux de commandes restent les mêmes que ceux précédemment décrits et sont identiques pour chaque quantificateur. La difficulté est de trouver la distance minimale parmi les N quantificateurs, et donc le vecteur le plus pertinent du dictionnaire, pour la vague en cours.

Plusieurs solutions peuvent être mises en oeuvre dans le cadre de l'invention.

La première est basée sur le fait que le signal $Z_{out}$, comme il a été montré, est l'inverse logique de la distance minimale. On peut utiliser cette information pour comparer les différents quantificateurs entre eux. De la même manière que les modules élémentaires sont éliminés à l'intérieur d'un quantificateur, on va pouvoir éliminer les quantificateurs mis en parallèles.

La figure 30 illustre la mise en parallèle de deux quantificateurs. Naturellement ce nombre n'a été choisi que pour ne pas surcharger inutilement le schéma. Un nombre plus important de mises en parallèles est parfaitement réalisable.

On a supposé que le nombre de vecteurs du dictionnaire DICO (non représenté) était égal à 2×16. Les signaux de commande ont été regroupés sous la référence générale $S_{com}$ et sont distribués de la même manière aux deux quantificateurs vectoriels $QV_A$ et $QV_B$. Les signaux de sortie $Z_{outA}$ et $Z_{outB}$ sont inversés par les portes logiques inverseuses, $INV_A$ et $INV_B$, respectivement. Finalement, les modules comparateurs $COMP_A$ et $COMP_B$, associés aux quantificateurs vectoriels $QV_A$ et $QV_B$, produisent des signaux $Z_A$ et $Z_B$, ainsi que deux drapeaux $F_A$ et $F_B$. Ces modules comparateurs jouent le rôle du module comparateur 6' de la figure 26. On peut utiliser les signaux $Z_A$ et $Z_B$, en les combinant à l'aide d'une porte logique OU $CL_{AB}$ en un signal unique Z, pour éliminer l'un ou l'autre des quantificateurs $QV_A$ ou $QV_B$, selon que le vecteur le plus performant est "vu" par le premier ou le second quantificateur vectoriel. Ce processus peut naturellement être étendu à N quantificateurs vectoriels, avec N>2.

Chacun des quantificateurs vectoriels $QV_A$ et $QV_B$ génère son propre mot d'adresse, $AD_{W/A}$ et $AD_{W/B}$ respectivement. L'une ou l'autre de ces adresses est utilisée en fonction du drapeau $F_A$ ou $F_B$ restant, indiquant par là quel est le meilleur vecteur du dictionnaire DICO à prendre en compte pour la vague en cours.

Dans la solution, qui vient d'être décrite, la logique mise en oeuvre au niveau du système global est très semblable à celle mise en oeuvre dans chaque quantificateur vectoriel. Elle consiste, à ce dernier niveau, à utiliser 16+1 modules comparateurs joints par un OU logique. On peut procéder de la sorte avec les (N × 16 + 1) distances. Pour ce faire, il suffit d'effectuer une légère modification de la configuration des circuits : on ouvre le signal de détection de zéro $Z_{out}$ à l'ensemble des quantificateurs. Pour ce faire, si on se reporte de nouveau à la figure 26, il suffit de couper physiquement la liaison entre la sortie de la porte logique CL' et l'entrée du registre $M_D$, autrement dit on ne reboucle plus directement ce signal sur le comparateur 6'.

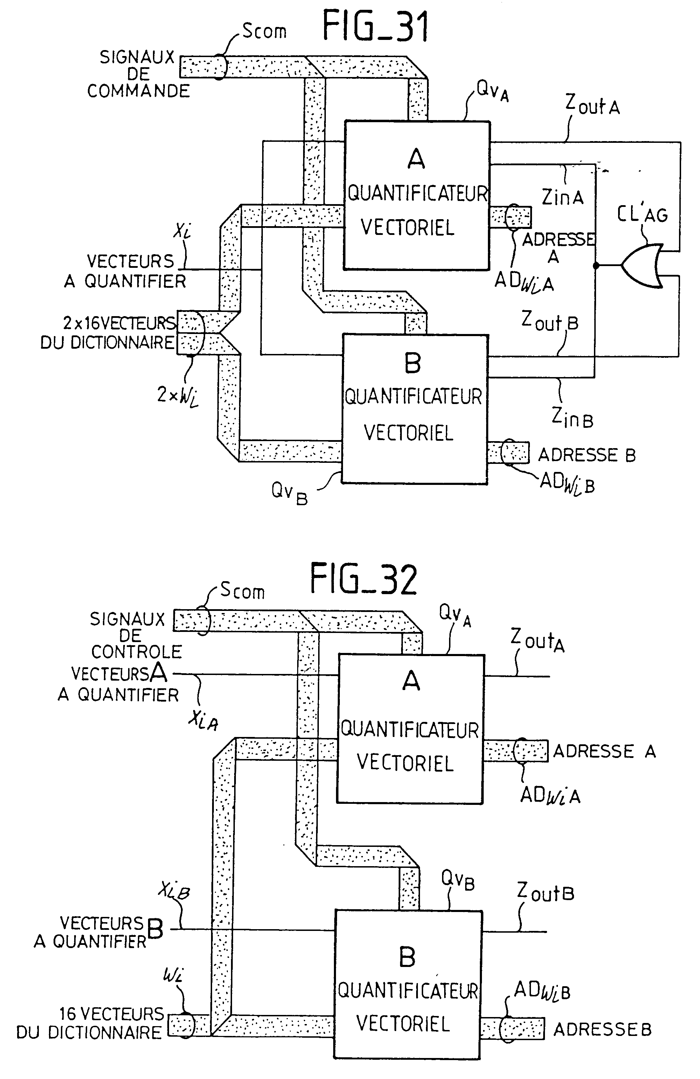

Si on considère de nouveau le cas de deux quantificateurs vectoriels en parallèle, le schéma global devient celui illustré par la figure 31. Les éléments identiques ou similaires à ceux de la figure 30 portent les mêmes références et ne seront pas redécrits. Les signaux $Z_{outA}$ et $Z_{outB}$ sont combinés en un OU logique par la porte $CL'_{AB}$ et sont rebouclés, sous la forme de signaux représentant l'inverse de la distance minimale : $Z_{inA}$ ou $Z_{inB}$, vers les comparateurs des deux quantificateurs vectoriels $QV_A$ et $QV_B$, ou de façon plus générale vers les N quantificateurs en parallèle.

Dans cette configuration, au lieu de travailler sur la distance minimale locale aux vecteurs qu'il traite, chaque quantificateur vectoriel effectue la comparaison sur le signal $Z_{in} = Z_{outA} + Z_{outB}$. On peut constater que ces signaux sont bien l'inverse logique de la distance minimale, comme il a été indiqué ci-dessus. En effet, les relations suivantes sont vérifiées :

$$Z_{inA} = Z_{inB} = Z_{in} = Z_{outA} + Z_{outB}$$

$$Z_{in} = Z_{minA} + Z_{minB} + \sum_{i \in A} Z_i + \sum_{i \in B} Z_i$$

$$Z_{minA} = Z_{minB} = Z_{min}$$

$$Z_{in} = Z_{min} + \sum_{i \in A \cup B} Z_i = \overline{\text{Distance Minimale}}$$

Une autre solution, duale des précédentes, est de quantifier simultanément plusieurs vecteurs d'entrée $X_i$, à l'aide d'un seul et même dictionnaire DICO. On utilise également, pour ce faire, plusieurs quantificateurs vectoriels en parallèle.

La figure 32 illustre un exemple d'un tel mode de réalisation, réduit à deux vecteurs à quantifier présentés en simultanéité. Les éléments identiques ou similaires à ceux des figures 30 ou 31 portent les mêmes références et ne seront pas redécrits. A chaque vague, les mêmes 16 vecteurs (dans l'exemple décrit) du dictionnaire DICO (non représenté) sont présentés simultanément aux deux quantificateurs vectoriels $QV_A$ et $QV_B$. Par contre deux vecteurs à quantifier différents, référencés $X_{iA}$ et $X_{iB}$, sont présentés en entrée. Chaque quantificateur, $QV_A$ ou $QV_B$, génère comme précédemment les signaux $Z_{outA}$ et $Z_{outB}$, d'une part, et les signaux d'adresse, $AD_{W/A}$ et $AD_{W/B}$. Ces deux séries de signaux sont associées aux vecteurs respectifs $X_{iA}$ et $X_{iB}$. Ces signaux sont traités de la manière précédemment décrite.

On peut naturellement utiliser N quantificateurs vectoriels en lieu et place de chacun des quantificateurs vectoriels $QV_A$ ou $QV_B$, selon l'une des configurations décrites en relation avec les figures 31 ou 32.

L'utilisation de N quantificateurs pour traiter N vecteurs à quantifier différents permet, d'une part, de multiplier pratiquement par N la vitesse globale de quantification et, d'autre part, autorise une simplification notable du câblage puisque les signaux de commande sont communs à tous les quantificateurs vectoriels. En outre, le même dictionnaire est utilisé par ces N quantificateurs vectoriels.

Il est cependant nécessaire de disposer des N vecteurs $X_{iN}$ à quantifier simultanément. En outre, les vecteurs présentés simultanément doivent avoir la même dimension. Dans l'application compression d'image, selon un mode préféré de l'invention, les vecteurs à quantifier sont susceptibles de présenter aléatoirement des dimensions variables (nombre de coordonnées), typiquement 3 ou 5 coordonnées comme illustré par la figure 4. On ne pourra donc pas utiliser ce mode de réalisation pour ce type d'application particulière.

Pour terminer la description du fonctionnement des dispositifs permettant la mise en oeuvre du procédé selon l'invention, il est utile de remarquer que le flux de données en série via certains registres intermédiaires permet l'exécution simultanée de plusieurs opérations, selon un mode connu sous le sigle anglo-saxon de "pipe-line". A titre d'exemple, une soustraction peut commencer avant la fin de l'addition du résultat de la soustraction précédente.

D'autre part, certaines opérations sont instantanées, au sens où leur résultat n'est pas tributaire de l'occurrence d'un front d'horloge pour être validé. L'addition, la soustraction et le calcul de la valeur absolue sont de ce type.

Pour fixer les idées, sans optimisation, des essais ont montré que la quantification d'un vecteur de dimension 3 nécessite 63 périodes d'horloge et la quantification d'un vecteur de dimension 5 nécessite 87 périodes d'horloge.

On peut également remarquer qu'il est inutile d'attendre le passage complet d'une vague complète de vecteurs du dictionnaire avant d'envoyer la vague suivante, car seul le résultat final est intéressant. On peut donc recourir à un chevauchement entre vagues successives.

Si $N_C$ est la dimension (en nombre de coordonnées d'un vecteur) et V le nombre de vagues de vecteurs du dictionnaire, les temps de quantification théoriques obéissent aux relations suivantes :
- sans chevauchement, $T = 21 \times V + 12 \times N_C \times V$ périodes d'horloge.
- avec chevauchement, $T = 9 + 12 \times V + 12 \times N_C \times V$ périodes d'horloge.

Diverses dispositions permettent d'optimiser encore le fonctionnement. On peut montrer notamment que le registre bidirectionnel 5 (de 12 bits dans exemple décrit) constitue un "goulot d'étranglement". L'utilisation de deux registres en alternance permettrait de gagner 13 périodes d'horloge entre deux vagues successives de vecteurs, ce naturellement au prix d'une légère augmentation de la complexité de la logique de commande.

Dans ce même ordre d'idée, il faut noter également que le recours au chevauchement complique la génération des signaux de commande. C'est notamment le cas de la compression d'image, avec des vecteurs de dimension variant aléatoirement, entre 3 et 5 coordonnées par exemple.

Le quantificateur vectoriel tel qu'il vient d'être décrit peut s'insérer dans un ensemble de circuits informatisés qui lui fournit les signaux de commande nécessaires à son bon fonctionnement, stocke les vecteurs du dictionnaire, les lui fournit et, enfin, génère les vecteurs à quantifier au format série.

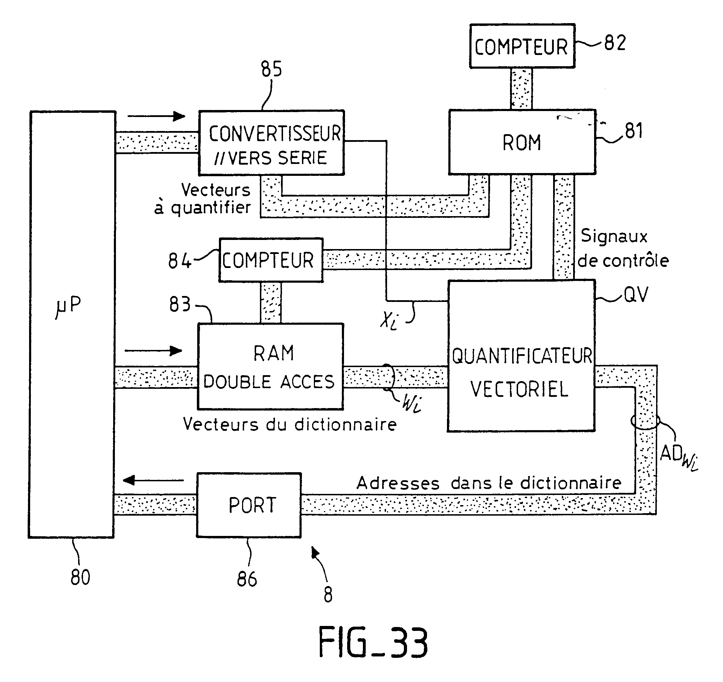

L'architecture d'un tel système est illustrée schématiquement par les circuits 8 de la figure 33.

Ces circuits 8 sont pilotés par un microprocesseur 80 qui génère également les vecteurs à quantifier. C'est, par exemple, ce microprocesseur qui va commander les étapes préliminaires de calcul de TCD (figure 2). Les vecteurs à quantifier doivent être présentés au format série comme il a été indiqué. Pour ce faire, on utilise notamment un convertisseur paralèlle-série 85 qui transmet les vecteurs à quantifer $X_i$ au quantificateur vectoriel QV.

Les signaux de commande sont générés par une mémoire morte de type "ROM" ("Read Only Memory" ou mémoire à lecture seule) 81. La capacité nécessaire de mémoire dépend naturellement du nombre d'états à générer. Elle dépend notamment de la taille des vecteurs et de celle des vecteurs du dictionnaire (nombre de vagues à traiter). Un compteur 82 génère de façon classique les adresse de lecture de la mémoire 81.

Les vecteurs du dictionnaire sont stockés physiquement dans une mémoire vive à accès aléatoire 83 ou "RAM" selon la terminologie anglo-saxonne usuelle. Le dictionnaire est chargé avant le début des opérations de quantification. Egalement, de façon habituelle, un compteur 84 génère les adresses de lecture de la mémoire 83. Le format de stockage, par contre, est particulier. 16 bits sont nécessaires pour chaque coordonnée de chaque vague de 16 vecteurs (dans l'exemple illustré). On a donc besoin de mots de 16 bits dont le premier est le bit de plus faible poids ("LSB") de la première des coordonnées des 16 premiers vecteurs. Le dernier est formé des 16 bits de signe de la dernière coordonnée des 16 derniers vecteurs du dictionnaire.

Un simple PORT 86 est utilisé pour récupérer l'adresse $AD_{Wi}$ en fin de quantification. Celle-ci est transmise, par exemple au microprocesseur 80 pour un traitement ultérieur selon l'art connu.

Seuls les éléments essentiels à la bonne compréhension de l'invention ont été représentés sur la figure 33. Un certain nombre de signaux classiques sont nécessaires : signaux d'horloge et de remise à zéro par exemple. Un signal de commande de démarrage du processus de quantification et un signal indiquant la disponibilité d'un résultat sont également nécessaires.

L'invention n'est pas limitée aux seuls exemples de réalisations précisément décrites en relation notamment avec les figures 3 à 33. De nombreux types de circuits, notamment des circuits intégrés configurables à la demande, peuvent être mis en oeuvre pour remplir les fonctions essentielles du quantificateur vectoriel selon l'invention.

Elle ne saurait être non plus limitée en quoique ce soit par les valeurs numériques qui n'ont été fournis qu'à titre d'exemple, pour fixer les idées.

Enfin, bien que particulièrement bien adaptée à l'application "compression d'images numériques en temps réel", le procédé de quantification vectoriel selon l'invention trouve application dans de nombreux autres domaines.

## Revendications

1. Procédé de quantification vectorielle d'un signal numérique comprenant les étapes de conversion de ce signal en un vecteur à quantifier $(X_i)$, au format série signé, de comparaison de ce vecteur à quantifier $(X_i)$ avec des vecteurs $(W_i)$ d'un dictionnaire (DICO) de même dimension que le vecteur à quantifier $(X_i)$, de détermination des distances binaires entre le vecteur à quantifier $(X_i)$ et les vecteurs $(W_i)$ du dictionnaire (DICO), de sélection de la distance minimale et de calcul de l'adresse $(AD_{Wi})$ du vecteur $(W_i)$ du dictionnaire (DICO) correspondant à ce vecteur, caractérisé en ce que,

   - l'étape de comparaison consiste à comparer, bits à bits, le vecteur à quantifier $(X_i)$ simultanément avec un nombre déterminé de vecteurs $(W_i)$ du dictionnaire (DICO);
   - l'étape de détermination des distances consiste à générer simultanément des mots binaires représentant les distances entre le vecteur à quantifier $(X_i)$ et les vecteurs $(W_i)$ du dictionnaire (DICO); et
   - l'étape de sélection de la distance minimale consiste à générer un signal de drapeau $(F_i)$ associé à chaque mot binaire et positionné à un premier état logique, à effectuer une séquence de comparaisons simultanées des bits desdits mots, en commençant par les bits de plus fort poids, à émettre pour chaque bit nul de chaque mot binaire un signal $(Z_i)$ détectant cet état, à émettre un signal supplémentaire (Z) représentant le "OU" logique de tous ces signaux, à un premier état logique lorsqu'au moins un des bits des mots binaires est nul, à comparer les bits de chaque mot binaire à ce signal supplémentaire (Z), à commuter lesdits signaux de drapeau $(F_i)$ des mots binaires, du premier état logique à l'état logique complémentaire, si le bit en cours de comparaison a la valeur "un" et si le signal supplémentaire (Z) est au premier état logique, et à éliminer les mots binaires associés à ces signaux de drapeau $(F_i)$ des comparaisons subséquentes, et à déterminer à partir des signaux de drapeau $(F_i)$ restés audit premier

état l'adresse (AD$_{Wi}$) du vecteur (W$_i$) du dictionnaire (DICO) le plus proche du vecteur à quantifier (X$_i$).

2. Procédé selon a revendication 1, caractérisé en ce que ledit dictionnaire (DICO) est partitionné en un nombre déterminé de vagues de vecteurs (W$_i$), chaque vague comprenant un nombre égal de vecteurs, en ce que l'étape de comparaison consiste à comparer, bits à bits, le vecteur à quantifier (X$_i$) avec tous les vecteurs (W$_i$) de chaque vague, cette étape étant réitérée jusqu'à ce que tous les vecteurs (W$_i$) du dictionnaire (DICO) aient été comparés au vecteur à quantifier (X$_i$), et en ce qu'il comprend les étapes supplémentaires consistant :

- à l'issue de la comparaison du vecteur à quantifier (X$_i$) avec tous les vecteurs (W$_i$) de chaque vague, à mémoriser un mot binaire représentant la distance minimale déterminée lors des vagues précédentes;
- à associer à ce mot binaire représentant la distance minimale un signal de drapeau particulier (Z$_{INVD}$) positionné audit premier état logique avant l'occurence de chaque nouvelle vague de vecteurs (W$_i$);
- à effectuer une séquence de comparaisons simultanées de ce mot représentant la distance minimale avec les bits de tous les autres mots binaires, en commençant par les bits de plus fort poids;
- à émettre pour chaque bit nul de ce mot binaire un signal (Z$_i$, Z$_{min}$) détectant cet état, ledit signal supplémentaire (Z) représentant en outre le "OU" logique de ce signal avec les signaux détectant un bit nul dans lesdits mots binaires;
- à comparer le bit du mot binaire représentant la distance minimale au signal supplémentaire (Z); et
- à commuter le signal de drapeau (Z$_{INVD}$) du mot binaire représentant la distance minimale, du premier état logique à l'état logique complémentaire, si le bit en cours de comparaison a la valeur "un" et si ledit signal supplémentaire (Z) est au premier état logique, et à éliminer le mot binaire représentant la distance minimale des comparaisons subséquentes;
- et en ce que l'adresse (AD$_{Wi}$) du vecteur (W$_i$) du dictionnaire (DICO) le plus proche du vecteur à quantifier (X$_i$) est déterminée à partir des signaux de drapeau (F$_i$, Z$_{INV}$D) associés aux mots binaires et au mot binaire représentant la distance minimale et restés audit premier état.

3. Procédé selon la revendication 2, caractérisé en ce qu'il comprend des étapes supplémentaires de comptage du nombre de vagues de vecteurs (Wi) successives et de génération d'un mot binaire représentant le nombre de vagues.

4 Procédé selon la revendication 3, caractérisé en ce que l'adresse (AD$_{Wi}$) du vecteur (W$_i$) du dictionnaire (DICO) le plus proche du vecteur à quantifier (X$_i$) est un mot binaire comportant un segment (No$_{Va}$) indiquant le numéro de vague déterminé à partir dudit mot binaire représentant le nombre de vagues de vecteurs (W$_i$) et un segment indiquant l'adresse du vecteur (No$_{Wi}$) dans une vague déterminée.

5. Procédé selon la revendication 1, caractérisé en ce que les vecteurs (W$_i$) du dictionnaire (DICO) sont associés à des indices indiquant des priorités croissantes et en ce que, lorsque plusieurs signaux de drapeau (F$_i$) restent audit premier état logique, il comprend une étape consistant à sélectionner le signal de drapeau (F$_i$) correspondant au vecteur de plus grande priorité.

6. Procédé selon l'une quelconque des revendications 2 à 4, caractérisé en ce que les vecteurs (W$_i$) du dictionnaire (DICO) sont associés à des indices indiquant des priorités croissantes et les vagues de vecteurs (W$_i$) à des numéros croissants; et en ce que lorsque plusieurs signaux de drapeau (F$_i$) restent audit premier état logique, il comprend une étape consistant à sélectionner le signal de drapeau (F$_i$) correspondant au vecteur de plus grande priorité et de plus faible numéro de vague.

7. Procédé selon l'une quelconque des revendications 1 à 6, caractérisé en ce que ledit dictionnaire (DICO) de vecteurs (W$_i$) comprend plusieurs sous-ensembles de vecteurs, chaque sous-ensemble comprenant au moins une vague de vecteurs, chaque vague comprenant le même nombre de vecteurs et chaque sous-ensemble le même nombre de vagues, la comparaison du vecteur à quantifier (X$_i$) est effectuée simultanément sur au moins une vague de vecteurs de chaque sous-ensemble.

8. Procédé selon l'une quelconque des revendications 1 à 6, caractérisé en ce que la comparaison est effectuée simultanément entre au moins deux vecteurs (X$_i$) à quantifier et au moins une vague de vecteurs d'un même dictionnaire (DICO).

9. Procédé selon l'une quelconque des revendications 1 à 8, caractérisé en ce que la dimension des vecteurs à quantifier (X$_i$) est variable.

10. Procédé selon l'une quelconque des revendications 1 à 9, caractérisé en ce que la distance entre un vecteur (W$_i$) du dictionnaire (DICO) et le vecteur à quantifier (X$_i$) est la distance de Minkowski d$_M$, obéissant à la relation suivante :

$$d_M = \Sigma |X_k - W_k| \text{ pour } k = 1 \text{ à } k_{max},$$

avec $X$ le vecteur à quantifier, $W$ un des vecteurs du dictionnaire (DICO) et k dimension maximale du vecteur à quantifier.

11. Procédé selon l'une quelconque des revendications 1 à 10, caractérisé en ce qu'il est appliqué à la compression en temps réel d'images numériques

12. Dispositif pour la mise en oeuvre du procédé selon l'une quelconque des revendications 1 à 11, caractérisé en ce qu'il comprend au moins des moyens de conversion (85) desdits signaux en une suite de vecteurs à quantifier ($X_i$), au format série signé, des moyens de génération et de stockage (83, 84) des vecteurs ($W_i$) du dictionnaire (DICO), des moyens de quantification vectorielle (QV) et un calculateur d'adresse (CA) générant un mot binaire représentant l'adresse ($AD_{Wi}$) du vecteur ($W_i$) du dictionnaire (DICO) le plus proche du vecteur à quantifier ($X_i$); en ce que les moyens de quantification vectorielle (QV) comprennent un nombre déterminé de modules quantificateurs élémentaires ($QV_n$) associés chacun à un vecteur ($W_i$) dudit dictionnaire (DICO), chaque module ($QV_n$) comportant des première et deuxième entrées ($e_X$, $e_W$) destinées à recevoir séquentiellement les bits respectifs d'un vecteur à quantifier ($X_i$) et du vecteur ($W_i$) du dictionnaire (DICO) qui lui est associé, les bits de poids le plus faible en premier, en ce que chaque module ($QV_n$) comprend des moyens (1 à 5) pour générer et mémoriser un mot binaire représentant la distance entre le vecteur à quantifier (Xi) et le vecteur ($W_i$) du dictionnaire (DICO) qui lui est associé, et des moyens de comparaison (6) pour comparer séquentiellement tous les mots binaires entre eux, bits à bits, les bits de poids le plus fort en premier; en ce que les moyens de comparaison (6) sont munis d'une première sortie générant un premier signal binaire, dit de drapeau ($F_i$), positioné à un premier état logique en début de comparaison et une deuxième sortie générant un deuxième signal binaire ($Z_i$) détectant un bit nul dans le mot binaire entrant dans le comparateur (6); en ce qu'il comprend des moyens logique (CL) effectuant un "OU" logique sur tous lesdits deuxièmes signaux binaires, générant un signal de sortie (Z) à un premier état logique lorsqu'au moins l'un des mots binaires comporte un bit nul, la sortie des moyens logiques étant rebouclée sur une troisième entrée ($S_{e1}$), commune à tous les comparateurs (6) modules de quantification élémentaires ($QV_n$); en ce que chaque moyen de comparaison (6) comprend un organe (60) détectant l'occurence dudit signal de sortie (Z) au premier état logique et de la valeur "un" du bit ($OUT_2$) du mot binaire en cours de comparaison, commutant lesdit signaux de drapeau ($F_i$), du premier état logique à l'état logique complémentaire, si cette occurence est réalisée et éliminant les moyens de comparaison (6) du module élémentaire ($QV_n$) des comparaisons subséquentes; et en ce que le calculateur d'adresse (CA) comprend un encodeur (70) générant, à partir des états logiques desdits signaux de drapeau ($F_i$), un mot binaire de sortie ($No_{Wi}$) représentant l'adresse ($AD_{Wi}$) du vecteur (Wi) du dictionnaire (DICO) le plus proche du vecteur à quantifier ($X_i$).

13. Dispositif selon la revendication 12, caractérisé en ce que des moyens pour générer et mémoriser un mot binaire représentant la distance entre le vecteur à quantifier ($X_i$) et le vecteur ($W_i$) du dictionnaire (DICO) qui lui est associé comprennent un registre à décalage bidirectionnel (5).

14. Dispositif selon les revendications 12 ou 13, caractérisé en ce que le dictionnaire (DICO) étant partitionné en plusieurs vagues de vecteurs ($W_i$), chaque vague comprenant un nombre égal de vecteurs et les vecteurs de chaque vague étant présentés séquentiellement aux modules quantificateurs élémentaires ($QV_n$) pour réaliser des comparaisons successives de ces vecteurs ($W_i$) avec le même vecteur à quantifier ($X_i$), il comprend en outre des moyens ($S_{MD}$) pour mémoriser un mot binaire représentant la distance minimale déterminée lors des comparaisons précédentes et des moyens de comparaison (6') pour comparer séquentiellement tous les mots binaires représentant les distances avec le mot binaire représentant la distance minimale, bits à bits, les bits de poids le plus fort en premier; en ce que ces moyens de comparaison (6') sont munis d'une première sortie générant un premier signal binaire ($Z_{INVD}$), dit de drapeau, positionné à un premier état logique en début de comparaison et une deuxième sortie générant un deuxième signal binaire ($Z_{min}$) détectant un bit nul dans le mot binaire entrant dans le comparateur (6); en ce qu'il comprend des moyens logiques (CL, CL') effectuant un "OU" logique sur tous lesdits deuxièmes signaux binaires ($Z_i$, $Z_{min}$), générant un signal de sortie (Z) à un premier état logique lorsque au moins l'un des mots binaires comporte un bit nul, la sortie des moyens logiques étant rebouclée sur une troisième entrée, commune à tous les comparateurs (6,6') des modules de quantification élémentaires ($QV_n$) et aux moyens de mémorisation de la distance minimale ($S_{MD}$, $C_{MD}$); en ce que chaque moyen de comparaison (6,6') comprend un organe (60) détectant l'occurence dudit signal de sortie au premier état logique et de la valeur "un" du bit du mot binaire en cours de comparaison ($OUT_2$), commutant ledit signal de drapeau ($F_i$, $Z_{INVD}$), du premier état logique à l'état logique complémentaire, si cette occurrence est réalisée et éliminant les moyens de comparaison (6, 6') des modules élémentaires (QVn) ou des moyens de mémorisation de la distance minimale ($S_{MD}$, $C_{MD}$) des comparaisons subséquente.

15. Dispositif selon la revendication 14, caractérisé en ce que le calculateur d'adresse (CA) comprend en outre un compteur (74) de vagues de vecteurs ($W_i$) et des moyens pour générer à partir dudit mot binaire de sortie ($No_{Wi}$) du décodeur (70) et de l'état de comptage ($No_{Va}$) de ce compteur, un mot binaire ($AD_1$ à $AD_8$) représentant l'adresse du vecteur ($W_i$) du dictionnaire (DICO) le plus proche du vecteur à quantifier ($X_i$) dans une vague de vecteurs ($W_i$) déterminée.

16. Dispositif selon la revendication 15 caractérisé en ce que, les vecteurs ($W_i$) du dictionnaire (DICO) étant associés à des indices indiquant des priorités croissantes, ledit encodeur est un encodeur à priorités préétablies de manière à ce que, lorsque plusieurs signaux de drapeau ($F_i$) restent audit premier état logique, le décodeur sélectione le signal de drapeau ($F_i$) correspondant au vecteur de plus grande priorité.

**17.** Dispositif selon l'une quelconque des revendications 12 à 16, caractérisé en ce que ledit dictionnaire (DICO) de vecteurs comprenant plusieurs sous-ensembles de vecteurs ($W_i$), chaque sous-ensemble comprenant au moins une vague de vecteurs, chaque vague comprenant le même nombre de vecteurs et chaque sous-ensemble le même nombre de vagues, il comprend plusieurs moyens de quantification vectorielle ($QV_A$, $QV_B$) disposés en parallèle, en nombre égal au nombre de sous-ensemble de vecteurs, chacun de ces moyens de quantification vectorielle recevant sur une première série d'entrées desdits modules élémentaires ($QV_n$) les vecteurs ($2 \times W_i$) appartenant à un desdits sous-ensembles et, sur une seconde série d'entrées, le vecteur à quantifier ($X_i$), le même vecteur à quantifier étant transmis à toutes les secondes entrées.

**18.** Dispositif selon l'une quelconque des revendications 12 à 16, caractérisé en ce qu'il comprend plusieurs moyens de quantification vectorielle ($QV_A$, $QV_B$) disposés en parallèle, chacun de ces moyens de quantification vectorielle recevant sur une première série d'entrées desdits modules élémentaires ($QVn$) les vecteurs d'au moins une vague de vecteurs ($W_i$) du dictionnaire (DICO), chaque vecteur étant présenté à tous les moyens de quantification vectorielle, et, sur une seconde série d'entrées, des vecteurs à quantifier ($X_{iA}$, $X_{iB}$), un vecteur à quantifier différent étant transmis à chacun desdits moyens de quantification vectorielle ($QV_A$, $QV_B$) disposés en parallèle.

# FIG_1

Image originelle TCD

Vectorisation

Recherche dans un dictionnaire

DICO

Indice

Codage de Huffmann

$Ph_1$

$Ph_2$

$Ph_3$

QUANTIFICATION VECTORIELLE

# FIG_2

$W_i$

Vecteurs du dictionnaire

QUANTIFICATION VECTORIELLE

DICO

Vecteurs à coder

$X_i$

Qv

Adresse dans le dictionnaire

$AD_{W_i}$

# FIG_3

$No_{V_a}$

$No_{W_i}$

| N° de vague | N° de vecteur |
|---|---|

Vague de 16 vecteurs du dictionnaire

$W_i$

Vecteur a coder

$X_i$

Dimension 3 ou 5

# FIG_4

# FIG_6

# FIG_5

Etapes

Distance $d_M$ au vecteur a quantifier $X_i$    Vecteurs $W_i$ du dictionnaire DICO

1    poids forts identiques pas de décision

| | | |
|---|---|---|
| 0 | 10010110111 (1207) | $W_1$ |
| 0 | 00110010100 (404) | $W_2$ |
| 0 | 00110100010 (418) | $W_3$ |
| 0 | 00110010111 (407) | $W_4$ |

2    bit de poids 1024 nul, sauf dans la 1ère distance $\Longrightarrow$ distance superieure aux autres d'au moins 1024. Elimination de $W_1$

| | |
|---|---|
| 1 0010110111 (1207) | $W_1$ |
| 00110010100 (404) | $W_2$ |
| 00110100010 (418) | $W_3$ |
| 00110010111 (407) | $W_4$ |

3 à 7    5 bits identiques. $\Longrightarrow$ pas de décision

| | |
|---|---|
| 00110 010100 (404) | $W_2$ |
| 00110 100010 (418) | $W_3$ |
| 00110 010111 (407) | $W_4$ |

8    bit de poids 32 nul, sauf dans la 2nde distance $\Longrightarrow$ distance supérieure aux autres. Elimination de $W_3$

| | |
|---|---|
| 0 10100 (20) | $W_2$ |
| 1 00010 (34) | $W_3$ |
| 0 10111 (23) | $W_4$ |

9 à 12    4 bits identiques, $\Longrightarrow$ pas de décision

| | |
|---|---|
| 0101 00 (20) | $W_2$ |
| 0101 11 (23) | $W_4$ |

13    bit de poids 2 nul, sauf dans la 2nde distance $\Longrightarrow$ élimination de $W_4$

| | |
|---|---|
| 0 0 (0) | $W_2$ |
| 1 1 (3) | $W_4$ |

14    dernier bit $\Longrightarrow$ choix de $W_2$

| | |
|---|---|
| 0 (0) | $W_2$ |

# FIG_7

Valeurs binaires des distances associées aux signaux $Z_i$ :

MSB         LSB

D=692   $Z_{i1}$     0 0 1 0 1 0 1 1 0 1 0 0 = 692

D=1226   $Z_{i2}$     0 1 0 0 1 1 0 0 1 0 1 0 = 1226

D=180   $Z_{i3}$     0 0 0 0 1 0 1 1 0 1 0 0 = 180

D=188   $Z_{i4}$     0 0 0 0 1 0 1 1 1 1 0 0 = 188

$Z_i$ = Distance

$F_{i1}$

$F_{i2}$       Distance minimale

$F_{i3}$

$F_{i4}$

$\Sigma Z_i$ = Distance min

# FIG_ 8

$X_i$

$W_{in}$

| 1 Sous-tracteur | 2 Registre décalage | 3 Valeur absolue | 4 Addition | 5 Registre à décalage bidirectionnel | 6 Compa-rateur |

Z

$Z_{in}$

$F_{in}$

H

# FIG_9

EN$_2$

EN$_1$

$X_i$

$W_{in}$

SET$_1$

1

SOUSTRACTEUR

CAR

SOUS

H

# FIG_10

H

$X_i$

$W_{in}$

SOUS

CAR

EN$_1$

EN$_2$

SET$_1$

RST

# FIG_11

EN$_3$

SOUS

2

| 201 | 202 | 203 | 204 | 205 | 206 | 207 | 208 |

OUTRG

H

RST

FIG_12

FIG_13

FIG_14

FIG_15

24

ABS
ORB$_1$
SOM
H
EN$_5$
RST$_1$

FIG_16

501 502 503 504 505 506 507 508 509 510 511 512
5

SOM

SENS
EN$_6$
RST$_2$
H

OUT$_2$

ORB$_1$

FIG_17

H
SOM
ORB$_1$
OUT$_2$
SENS
EN$_6$
RST$_2$

FIG_18

6

OUT$_2$

Z

SET$_3$

EN$_7$

H

RST

61

62  63

60

64

Z$_i$

F$_i$

FIG_19

FIG_20

FIG_21

FIG_22

FIG_23

# FIG_24

H

Z

ORG

EN

RST

# FIG_25

H

Z

ORG

EN

RST

Distance

drapeaux
$F_i$

signaux
$Z_i$

CL

Comparateur

FIG_26

Sci

Comparateur

$S_{M2}$

Signal
$Z_{INVD}$

$Z_{min}$

$S_{M1}$

CL'

$Z_{out}=Z_{min}+\Sigma_{\Delta}$
= Distance minimale

Distance
minimale
des vagues
précédentes

INV

Registre
12 bits

Sel

$M_D$

# FIG_27

# FIG_28

28

# FIG_29

# FIG_30

## FIG_31

## FIG_32

COMPTEUR —82

85

CONVERTISSEUR //VERS SERIE

ROM —81

Vecteurs à quantifier

Signaux de contrôle

84— COMPTEUR

$X_i$

QV

µP

83—

RAM DOUBLE ACCES

QUANTIFICATEUR VECTORIEL

$W_i$

Vecteurs du dictionnaire

$AD_{W_i}$

Adresses dans le dictionnaire

PORT

80

86

8

FIG_33

EP 0 667 680 A1

**Office européen des brevets**

# RAPPORT DE RECHERCHE EUROPEENNE

Numero de la demande

EP 95 40 0259

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | IEEE INTERNATIONAL CONFERENCE ON SYSTEMS ENGNEERING, NEW YORK (US), page 214 KAUL ET AL 'an all digital implementation of a modified hamming net for video compression with prediction and quantization circuits' --- | 1,5,9,11 | H03M7/30 H04N7/28 |
| A | PROCEEDINGS OF EUSIPCO-92, vol. 3, BRUSSELS (BE), page 1521 LEE AND JUAN 'vlsi implementation of a modified-vq encoder suitable for image/video applications' * figure 5B * --- | 1,5 | |
| A | 1990 IEEE INTERNATIONAL SYMPOSIUM ON CIRCUITS AND SYSTEMS, vol. 4, NEW YORK (US, page 3034 DEZHGOSHA ET AL 'a codebook,distortion and comparator (cdc) chip,architecture for real time coding' * le document en entier * ----- | 1 | DOMAINES TECHNIQUES RECHERCHES (Int.Cl.6) H03M H04N |

Le présent rapport a été établi pour toutes les revendications

| Lieu de la recherche | Date d'achèvement de la recherche | Examinateur |
|---|---|---|
| LA HAYE | 26 Avril 1995 | Feuer, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

32